(19) Europäisches Patentamt
European Patent Office
Office européen des brevets

(11) EP 1 380 855 A2

(12) **EUROPEAN PATENT APPLICATION**

(43) Date of publication:
**14.01.2004 Bulletin 2004/03**

(51) Int Cl.[7]: **G02B 1/02**, G02B 1/12, B01L 5/00

(21) Application number: **03015384.5**

(22) Date of filing: **08.07.2003**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **08.07.2002 JP 2002198165**
**24.04.2003 JP 2003120304**
**22.05.2003 JP 2003144825**

(71) Applicants:
- **Showa Denko K.K.**
  **Tokyo (JP)**
- **NIKON CORPORATION**
  **Tokyo (JP)**

(72) Inventors:
- **Hoshino, Yasuyuki**
  **Kawasaki-shi, Kanagawa (JP)**
- **Taki, Yusuke**
  **Chiyoda-ku, Tokyo (JP)**

(74) Representative: **Strehl Schübel-Hopf & Partner**
**Maximilianstrasse 54**
**80538 München (DE)**

(54) **Apparatus and process for fluorination treatment of substrates**

(57) Disclosed is a fluorination treatment apparatus comprising a fluorine gas storage/feed vessel for storing and feeding a fluorine gas, a reactor for bringing a substance to be treated into contact with a fluorine gas to carry out fluorination reaction, and a fluorine gas pipe arranged between the fluorine gas storage/feed vessel and the reactor. Also disclosed is a process for producing a fluorination treated substance, comprising an enclosure step of enclosing a substance to be treated in a reactor and a fluorination reaction step of introducing a fluorine gas into the reactor to bring the substance to be treated into contact with the fluorine gas and thereby carry out fluorination reaction. According to the invention, a fluorination treated substance remarkably reduced in the light absorption loss of a substance to be treated, such as a fluoride thin film, a fluorination treatment apparatus capable of producing the fluorination treated substance, and a process for producing a fluorination treated substance can be provided.

EP 1 380 855 A2

## Description

### FIELD OF THE INVENTION

The present invention relates to a fluorination treatment apparatus for forming a fluorine atmosphere freed of impurity contamination to treat a substance to be treated, a process for producing a fluorination treated substance, and a fluorination treated substance obtained by the process.

The present invention also relates to a process for producing a fluorination treated substance, in which a fluoride optical element obtained by surface abrasion is cleaned by fluorination treatment to obtain a fluoride optical element having a smooth and clean surface, and a fluorination treated substance obtained by the process.

The present invention further relates to a process for producing a fluorination treated substance, in which a fluoride optical thin film is densified by heat treatment in a fluorine gas atmosphere to obtain a fluoride optical element having a densified optical thin film, and a fluorination treated substance obtained by the process.

### BACKGROUND OF THE INVENTION

Differently from nitrides and oxides, fluoride materials are transparent in the vacuum ultraviolet region of not more than 180 nm wavelength, so that they are indispensable for optical elements for the vacuum ultraviolet region, such as lenses and prisms, and optical thin films, such as anti-reflection films, deflection films or reflection films, which are formed on the surfaces of the optical elements.

With the recent high integration and high densification of semiconductor integrated circuits, fine circuit patterns have been desired, and in order to produce such fine circuit patterns by photolithography, it becomes essential to develop a reduction projection exposure apparatus for producing semiconductor circuits using vacuum ultraviolet light as an exposure light. For the reduction projection exposure apparatus using vacuum ultraviolet light, various optical elements and optical thin films made of fluorides are employed.

In the reduction projection exposure apparatus, several tens of fluoride optical elements of various shapes and purposes are arranged between the laser beam source and the wafer where the semiconductor circuit is exposed, and the surfaces of these optical elements are coated with fluoride thin films satisfying their purposes. Since the optical element materials and the fluoride thin films have some light absorption, the quantity of light reaching the wafer surface becomes considerably small. To enhance the exposure performance and the productivity, loss of light quantity must be made as small as possible. That is to say, as the light absorption of each optical element and each thin film is decreased, the performance of the exposure apparatus is more enhanced.

The optical element materials themselves have been earnestly studied and developed over a long period of time, and as a result, defects or impurities causing light absorption have been decreased as much as possible, and scattering on the element surface has also been reduced by virtue of development of the abrasion technique.

On the other hand, the optical thin films are readily formed at relatively low temperatures by various PVD methods, such as vacuum deposition using resistance heating or electron beam melting, vacuum deposition using ion assist in combination, ion plating, sputtering, and ion beam sputtering. The reason why the thin film must be formed only by heating the optical element as a substrate at a relatively low temperature is that high-temperature heating causes thermal deformation of the optical element to thereby produce deviation of the dimensional accuracy of the optical element surface, so that desired performance of image formation cannot be obtained.

The fluoride optical thin film formed on the optical element by heating at a relatively low temperature as described above has light absorption markedly larger than that of a bulky fluoride solid formed at a high temperature over a sufficient period of time. The reasons why the vacuum ultraviolet absorption of the thin film is particularly larger than that of the bulk are as follows: the fluoride optical thin film is deficient in fluorine in comparison with the stoichiometric composition, to bring about dangling bonds; to the fluorine-deficient atomic site, an oxygen atom or a hydroxyl group is bonded, and such a bond absorbs light; the fluoride optical thin film has poorer crystalline properties than the bulk, and contains many structural defects; and the fluoride optical thin film has a larger specific surface area than the bulk, so that extremely large amounts of water content or organic matters are adsorbed, and these adsorbed matters absorb light.

Since both surfaces of the optical element are coated with the optical thin films, the number of the surfaces coated is twice the number of the optical elements. Therefore, if optical thin films suffering fluorine deficiency, structural disorder, oxidation/hydroxylation and water content/organic matter adsorption and having large light absorption are mounted on the vacuum ultraviolet exposure apparatus, the quantity of light reaching the wafer surface through these several tens of optical thin films becomes extremely small, e.g., about several % of the original quantity of light released from the light source. Consequently, the exposure time is prolonged, and the productivity becomes extremely bad. That is to say, the most of the exposure performance is decided by the optical thin film. Further, a fluorine-deficient fluoride thin film or a fluorine-deficient and oxygen-containing fluoride thin film has poor laser beam resistance because such a film contains structural defects or impurities, and hence the optical element parts need to be changed frequently to further deteriorate productivity of the exposure apparatus.

From the results of the recent active studies, regarding the materials of fluoride optical elements or fluoride optical thin films, methods for reducing defects or the amounts of impurities causing light absorption have been proposed. For example, in Japanese Patent Laid-Open Publication No. 315893/1997, there is proposed a method for producing high-purity calcium fluoride single crystal containing small amounts of impurities, in which pretreatment using a scavenger is carried out prior to the growing stage to obtain a high-purity pretreated substance. In Japanese Patent Laid-Open Publication No. 264512/2001, there is proposed a method for compensating fluorine deficiency, in which a fluorine-deficient fluoride thin film deposited on a substrate is enclosed in an active fluorine atmosphere to fluorinate the whole film. However, development of technique to further decrease the light absorption loss (loss due to light absorption) of a substance to be treated, such as a fluoride thin film, a fluoride powder, a fluoride solid or a fluoride optical element, has been still desired.

The present inventors have earnestly studied, and as a result, they have made it clear that because the fluorine gas has the highest reactivity among all elements, the fluorine gas sometimes undergoes chemical reactions with various substances present in a fluorine gas feed line and a treatment apparatus, and because some of the matters formed by the chemical reactions contaminate the optical elements themselves enclosed in the treatment apparatus, the effect in the enhancement of transmittance due to the fluorination treatment is not exerted to the utmost.

In the production of an optical element, e.g., lens or prism, utilizing vacuum ultraviolet light, a fluoride solid in a desired optical element shape such as lens or prism is generally formed by performing operations of cutting, grinding, rough abrasion and precision abrasion (final abrasion) in this order. The result of the precise abrasion is generally judged by measuring surface profile of the abraded surface by an interferometer and determining a RMS (root mean square) value indicating a degree of deviation of the measured value from the designed value. In the case where a wavelength (nm) of light is denoted by $\lambda$, the precision abrasion is judged to be completed only when the RMS value of the abraded surface reaches not more than several to several tens $\lambda/10000$. That is to say, as the wavelength of light used becomes shorter, higher finish accuracy is required for the abraded surface, and only when the precise abrasion satisfying such conditions is completed, an optical element showing optical properties of designed values can be obtained. The optical element thus obtained is then cleaned using neutral detergent, distilled water and isopropyl alcohol successively to remove abrasive grains and organic matters remaining on the surface of the optical element.

With regard to the fluoride optical element obtained by such surface abrasion, development of technique to further decrease the light absorption loss of the fluoride optical element itself has been eagerly desired.

Under such circumstances, the present inventors have earnestly studied, and as a result, they have found that when the fluoride optical element for the vacuum ultraviolet light of shorter wavelength is subjected to conventional cleaning after the precision abrasion (final abrasion), there is a new problem peculiar to the fluoride optical element obtained by the surface abrasion.

After the precision abrasion (final abrasion), abrasive grains remain on the surface of the fluoride optical element. When the surface of the fluoride optical element is cleaned by a conventional cleaning method using neutral detergent, distilled water and isopropyl alcohol successively, most of the abrasive grains and the organic matters remaining on the optical element surface are removed. By the conventional cleaning method, however, trace amounts of abrasive grains sticking into the fluoride optical element surface or a work-modification layer formed on the fluoride optical element surface as a result of chemical reaction of the fluoride optical element surface with the abrasive grains cannot be removed. The present inventors have clarified that the light absorption loss attributable to the abrasive grains sticking into the fluoride optical element surface or the work-modification layer formed on the surface exerts great influence on the light absorption loss of the whole fluoride optical element, and they have found a method of removing the abrasive grains sticking into the surface and the work-modification layer formed on the surface. Based on the finding, the present invention has been accomplished. The above problem makes no matter in the conventional wavelength region which has been used by the fluoride optical elements, i.e., the infrared-visible-ultraviolet region.

In the semiconductor exposure apparatuses using KrF excimer laser of ultraviolet wavelength (248 nm) and ArF excimer laser of deep ultraviolet wavelength (193 nm) as exposure light sources, optical elements, such as lens, mirror and prism, are enclosed in a mirror tube, and in the mirror tube, a nitrogen gas is passed. These optical elements are usually coated with optical thin films, such as anti-reflection films, high reflection films and semi-transmission films.

The optical element material itself is synthesized using, as starting materials, a high-purity powder and a reactive gas at a high temperature of not lower than 1000°C in order to sufficiently promote the reaction. After the synthesis, the optical element material is slowly cooled over a sufficient period of time and then subjected to annealing if desired, so that impurity atoms, defects and distortion which may cause light absorption or scattering are removed. Further, scattering on the optical element surface has been reduced by virtue of the development of abrasion technique.

On the other hand, the optical thin film is readily formed at a relatively low temperature by various PVD methods, such as vacuum deposition using resistance heating or electron beam melting, vacuum deposition using ion assist, ion plating, sputtering, and ion beam sputtering. The reason why the thin film must be formed only by heating the optical element as a substrate at a relatively low temperature is that high-temperature heating causes thermal deformation of the optical element to thereby produce deviation of the dimensional accuracy of the optical element surface, so that desired performance of image formation cannot be obtained.

By the way, the optical element material formed at a high temperature over a long period of time is a dense bulky solid and has no voids which are invaded by various gas molecules. However, the optical thin film formed on the optical element at a relatively low temperature as described above has a porous structure abundant in pores and voids and having an extremely large specific surface area, so that very large amounts of water vapor, volatile organic matters and volatile inorganic matters invade and are adsorbed inside. Most of the volatile organic matters and the volatile inorganic matters absorb light of ultraviolet KrF excimer laser wavelength and light of deep ultraviolet ArF excimer laser wavelength. Further, light of the vacuum ultraviolet $F_2$ laser wavelength (157 nm) used as an exposure light of a semiconductor exposure apparatus of the next generation is absorbed even by water vapor.

Although a nitrogen gas is passed inside the mirror tube where the optical element is enclosed in the semiconductor exposure apparatus, trace amounts of volatile organic matters, volatile inorganic matters such as ammonia and water vapor contained in the environment of the semiconductor exposure apparatus and the nitrogen gas are introduced into the mirror tube. The volatile organic matters, volatile inorganic matters and water vapor introduced into the mirror tube adhere onto the optical thin film formed on the optical element surface or invade the optical thin film deeply through the voids or pores of the film and are adsorbed to cause light absorption. Moreover, after the laser beam irradiation, those matters undergo polymerization or fixation to further lower the light transmittance.

In the reduction projection semiconductor exposure apparatus, several tens of optical elements of various shapes and purposes are arranged between the laser beam source and the wafer where the semiconductor circuit is exposed, and both surfaces of these optical elements, i.e., both surfaces on the light entrance side and the light exit side, are coated with optical thin films. That is to say, the number of the surfaces coated is twice the number of all of the optical elements. In one semiconductor exposure apparatus, the optical elements used are all arranged in the same mirror tube, so that they are almost equally contaminated with the volatile organic matters, volatile inorganic matters and water vapor and are lowered in the light transmittance. If the transmittance of one side surface of a certain optical element is denoted by T and a decrease (lowering) of the transmittance by contamination is denoted by $\Delta T$, the both-side transmittance of the optical element after contamination becomes $(T-\Delta T)^2$. If the number of all the optical elements is denoted by n, a decrease of the transmittance of the whole system becomes $(T-\Delta T)^{2n}$. Therefore, if the optical elements are contaminated, the quantity of light which is released from the laser beam source, transmitted by all of the several tens of optical elements and reaches the wafer surface becomes deadly small as compared with the ideal case where the optical elements are not contaminated at all. As a matter of course, it is impossible to completely remove the volatile organic matters, volatile inorganic matters and water vapor introduced into the mirror tube though an attempt to reduce them as much as possible is made, so that a lowering of transmittance attributable to adsorption, polymerization or fixation of the volatile organic matters, volatile inorganic matters and water vapor is an unavoidable problem. After all, the quantity of light reaching the wafer surface through these several tens of optical thins films becomes extremely small, e.g., about several % of the original quantity of the light released from the light source. On this account, the exposure time is prolonged, and the frequency of changes of optical elements is increased because of the thickly deposited polymerization products. Hence, the productivity is markedly lowered.

Accordingly, it has been particularly desired to protect the fluoride optical element having a fluoride optical thin film laminated thereon from lowering of light transmittance attributable to contamination of the fluoride thin film laminated on the optical element.

## OBJECT OF THE INVENTION

It is a first object of the present invention to provide a fluorination treatment apparatus capable of remarkably reducing fluorine deficiency of a substance to be treated, such as a fluoride thin film, to enhance transmittance in the vacuum ultraviolet region, a process for producing a fluorination treated substance, and a fluorination treated substance obtained by the process.

It is a second object of the present invention to provide a process for producing a fluoride optical element, wherein trace amounts of abrasive grains sticking into the abraded surface of the fluoride optical element and a work-modification layer formed on the surface are removed to obtain a fluoride optical element reduced in the small light absorption loss and having a smooth and clean surface, and a fluoride optical element obtained by the process.

It is a third object of the present invention to provide a process for producing a fluorination treated substance, wherein the structure of a fluoride optical thin film laminated on a fluoride optical element is densified, and a fluorination treated substance having a fluoride optical thin film densified by the process.

SUMMARY OF THE INVENTION

The present invention relates to the following (1) to (26).

(1) A fluorination treatment apparatus comprising a fluorine gas storage/feed vessel for storing and feeding a fluorine gas, a reactor for bringing a substance to be treated into contact with a fluorine gas to carry out fluorination reaction, and a fluorine gas pipe arranged between the fluorine gas storage/feed vessel and the reactor, wherein at least a portion to be brought into contact with the fluorine gas is constituted of a material having a chromium concentration of not more than 1% and/or a titanium concentration of not more than 1%.
(2) The fluorination treatment apparatus as stated in (1), wherein the material of at least a portion to be brought into contact with the fluorine gas is at least one of nickel, a nickel alloy, copper, a copper alloy, aluminum and an aluminum alloy.

According to the fluorination treatment apparatus as stated in (1) or (2), fluorine deficiency of the substance to be treated can be compensated by carrying out the fluorination treatment. Further, not only the fluorine deficiency of the substance to be treated can be compensated but also impurities are decreased, whereby the substance to be treated can be converted into a fluoride of stoichiometric composition. Hence, light absorption loss in the vacuum ultraviolet region and the ultraviolet region can be reduced. By carrying out the fluorination treatment, furthermore, crystalline properties of the substance to be treated can be enhanced and the structural defects can be decreased. By carrying out the fluorination treatment, moreover, laser beam resistance of the substance to be treated can be enhanced.
(3) A process for producing a fluorination treated substance, comprising:

an enclosure step of enclosing a substance to be treated in a reactor, and
a fluorination reaction step of introducing a fluorine type gas into the reactor to bring the substance to be treated into contact with the fluorine type gas and thereby carry out fluorination reaction.

(4) A process for producing a fluorination treated substance, comprising:

an enclosure step of enclosing a substance to be treated in a reactor,
a fluorination reaction step of carrying out fluorination reaction of the substance to be treated which has been enclosed in the reactor, and
a heat treatment step of heating the substance to be treated which has been enclosed in the reactor, to the prescribed temperature.

(5) A process for producing a fluorination treated substance, comprising:

an enclosure step of enclosing a substance to be treated in a reactor,
a water content exhaust step of exhausting water content from the reactor,
a fluorination reaction step of carrying out fluorination reaction of the substance to be treated which has been enclosed in the reactor,
a cooling step of cooling the substance to be treated which has been enclosed in the reactor, and
a withdrawal step of withdrawing the treated substance from the reactor,
wherein the treating temperature in the water content exhaust step is in the range of 100 to 170°C, and
the temperature in the reactor in the fluorination reaction step is in the range of 10 to 150°C, and the fluorine concentration in the reactor in this step is in the range of 1000 ppm to 100%.

(6) A process for producing a fluorination treated substance, comprising:

an enclosure step of enclosing a substance to be treated in a reactor,
a water content exhaust step of exhausting water content from the reactor,
a fluorination reaction step of carrying out fluorination reaction of the substance to be treated which has been enclosed in the reactor,
a heat treatment step of heating the substance to be treated which has been enclosed in the reactor, to the prescribed temperature,
a cooling step of cooling the substance to be treated which has been enclosed in the reactor, and
a withdrawal step of withdrawing the treated substance from the reactor,
wherein the temperature in the reactor in the fluorination reaction step is in the range of 10 to 150°C, and the fluorine concentration in the reactor in this step is in the range of 1000 ppm to 100%, and

the temperature in the reactor in the heat treatment step is higher than the temperature in the reactor in the fluorination reaction step, and the fluorine concentration in the reactor in the heat treatment step is lower than the fluorine concentration in the reactor in the fluorination reaction step.

(7) The process for producing a fluorination treated substance as stated in any one of (3) to (6), wherein the fluorination reaction step has:

a pressure control step of controlling the total pressure and the fluorine partial pressure in the reactor to the prescribed pressures, and
a temperature control step of controlling the temperature in the reactor to the prescribed temperature.

(8) The process for producing a fluorination treated substance as stated in any one of (3) to (7), wherein the total pressure in the reactor in the fluorination reaction step is in the range of 0.01 to 1.0 MPa.
(9) The process for producing a fluorination treated substance as stated in any one of (3) to (8), wherein the fluorination treatment apparatus of (1) or (2) is employed.
(10) The process for producing a fluorination treated substance as stated in any one of (3) to (9), wherein the substance to be treated is any one of a fluoride thin film, a fluoride powder, a fluoride solid and a fluoride optical element.
(11) The process for producing a fluorination treated substance as stated in (10), wherein the substance to be treated is a fluoride optical element obtained by abrading a surface of a fluoride solid with abrasive grain.
(12) The process for producing a fluorination treated substance as stated in (11), wherein the fluorination reaction step is a step of cleaning the fluoride optical element that is the substance to be treated.
(13) The process for producing a fluorination treated substance as stated in (11) or (12), wherein the abrasive grain is at least one material selected from the group consisting of silicon dioxide, silicon carbide, boron carbide, cubic boron nitride and diamond.
(14) The process for producing a fluorination treated substance as stated in (13), wherein the abrasive grain is silicon dioxide.
(15) The process for producing a fluorination treated substance as stated in any one of (11) to (14), wherein the temperature in the reactor in the fluorination reaction step is in the range of 10 to 500°C.
(16) The process for producing a fluorination treated substance as stated in (10), wherein the fluoride optical element is a fluoride optical element having a fluoride optical thin film laminated thereon.
(17) The process for producing a fluorination treated substance as stated in (16), wherein the fluorination reaction step is a step of heating the fluoride optical thin film to densify the film.
(18) The process for producing a fluorination treated substance as stated in (16) or (17), wherein the temperature in the reactor in the fluorination reaction step is in the range of 200 to 400°C, and the fluorine gas concentration in the reactor in this step is in the range of 10 ppm to 100%.
(19) The process for producing a fluorination treated substance as stated in any one of (10) to (18), wherein the fluoride thin film, the fluoride powder, the fluoride solid and the fluoride optical element are each constituted of at least one material selected from the group consisting of magnesium fluoride, calcium fluoride, lithium fluoride, lanthanum fluoride, aluminum fluoride, neodymium fluoride, gadolinium fluoride, yttrium fluoride, dysprosium fluoride, barium fluoride, sodium fluoride, bismuth fluoride, strontium fluoride, lead fluoride, selenium fluoride, cryolite and chiolite.
(20) The process for producing a fluorination treated substance as stated in any one of (3) to (19), wherein the fluorine type gas is at least one gas selected from the group consisting of a pure fluorine gas; a fluorine gas diluted with at least one rare gas of helium, neon, argon, krypton and xenon; a gas containing fluorine atoms released during the treatment from the inner surface of the reactor having been previously fluorinated; a gas containing fluorine atoms released during the treatment from a previously fluorinated metal, a fluorine-excess alloy or a fluorine-excess fluoride placed in the reactor; a fluorine gas generated by electrolysis of a metallic fluoride; a gas obtained by sublimating or evaporating a fluorine-rare gas compound of $XeF_2$, $XeF_4$ or $XeF_6$ and a fluorine gas generated by decomposition of the fluorine-rare gas compounds; and a gas containing active fluorine of fluorine radical or fluorine ion generated by dissociating at least one of a carbon-fluorine compound, a sulfur-fluorine compound and a nitrogen-fluorine compound.
(21) The process for producing a fluorination treated substance as claimed in any one of (3) to (20), wherein the fluorine type gas contains a fluorine gas.
(22) The process for producing a fluorination treated substance as stated in any one of (3) to (21), wherein the fluorine type gas is a gas containing fluorine generated by dissociating a fluorine-containing compound containing at least one material selected from the group consisting of carbon fluoride, sulfur fluoride, nitrogen fluoride, metallic fluoride, hydrogen fluoride, halogen fluoride and fluoride of a rare gas, by means of heat, electricity or plasma, or a fluorine gas.

(23) A fluorination treated substance obtained by the process of any one of (3) to (22).

(24) The fluorination treated substance as stated in (23), which is a fluoride optical element.

(25) A fluorination treated substance being a fluoride optical element obtained by the process of any one of (12) to (15), wherein the difference in the light absorption loss of the surface at 157 nm between before and after the fluorination treatment is not less than 0.1%.

(26) A fluorination treated substance obtained by the process of any one of (16) to (18), which is a fluoride optical element having a fluoride optical thin film whose pores capable of being invaded by water vapor, a volatile organic matter and a volatile inorganic matter are closed.

In the fluorination treated substances as stated in (23) to (26), namely, fluoride thin film, fluoride powder, fluoride solid and fluoride optical element, the fluorine deficiency has been compensated and the impurities have been decreased, that is, the substances have been converted into fluorides of stoichiometric composition. Hence, light absorption loss in the vacuum ultraviolet region and the ultraviolet region can be reduced. In these substances, further, the crystalline properties have been enhanced, the structural defects have been decreased, and the laser beam resistance has been enhanced.

The present application claims the priority generated on Japanese Patent Application No. 198165/2002, Japanese Patent Application No. 120304/2003 and Japanese Patent Application No. 144825/2003, and these applications are cited to the present application.

BRIEF DESCRIPTION OF THE DRAWINGS

Fig, 1 is a view to explain constitution of a fluorination treatment apparatus in an embodiment of the present invention.

Fig. 2 is a view to explain a fluorination treatment apparatus (apparatus for densifying optical thin film) in an embodiment of the present invention in the case where the substance to be treated is a fluoride optical element having a fluoride optical thin film laminated thereon.

Fig. 3 is a graph showing change in film optical loss before and after the fluorination reaction (fluorination heat treatment) and chromium concentration detected from a $MgF_2$ film surface after the fluorination reaction, which are given when the fluorination reaction (fluorination heat treatment) is carried out in Example 1 Comparative Example 1 and Comparative Example 2.

Fig. 4 shows results of SIMS measurements of O atom concentration and OH concentration of a $LaF_3$ film in the film depth direction before and after the fluorination reaction in Example 1.

Fig 5 is a graph showing measurement results of spectral transmittance of an optical element wherein an anti-reflection film consisting of alternately laminated layers of $MgF_2$ and $LaF_3$ is formed on both surfaces of a fluorite substrate in the form of a plain parallel plate (thickness: 3 mm).

Fig. 6 is a graph showing results obtained by continuously measuring transmittance with irradiating five optical elements arranged with $F_2$ laser beam in Example 2, each of said elements being equivalent to that of Fig. 5.

Fig. 7 shows results of TOF-SIMS measurements of optical elements obtained in Example 3 and Comparative Example 3.

Fig. 8 shows vacuum ultraviolet transmittance spectra of optical elements obtained in Example 3 and Comparative Example 3.

Fig. 9 shows vacuum ultraviolet absorption loss spectra of optical elements obtained in Example 3 and Comparative Example 3.

Fig. 10 is a schematic view of a fluorine generation source used in Example 4.

Fig. 11 is a schematic view of a fluorine generation source used in Example 6.

Fig. 12 shows sectional SEM photographs of a $MgF_2$ film, taken before and after the fluorination treatment (densification) in Example 7.

Fig. 13 is a constitutional view of a laser beam irradiation laboratory device used in Example 8.

Fig. 14 shows transmittance spectra of an as-depo film of a $MgF_2$/$LaF_3$ alternate-laminated anti-reflection film formed on a fluorite substrate, measured before and after the ArF excimer laser beam irradiation cloudiness test in Example 8.

Fig. 15 shows transmittance spectra of a densified film of a $MgF_2$/$LaF_3$ alternate-laminated anti-reflection film formed on a fluorite substrate, measured before and after the ArF excimer laser beam irradiation cloudiness test in Example 8.

Fig. 16 shows transmittance spectra of an as-depo film, a film having been densified in a fluorine atmosphere and a film having been densified in a helium atmosphere, of a $MgF_2/LaF_3$ alternate-laminated anti-reflection film (for 157 nm) formed on a fluorite substrate in Comparative Example 5.

1: fluorine gas storage/feed vessel (fluorine gas generation source)
2: helium gas cylinder
3: gas pipe (gas feed pipe, gas inlet)
4: valve
5: reactor (cleaning vessel, treatment vessel)
6: fixture for substance to be treated (fluoride optical element)
7: fluoride optical element
8: temperature-measuring thermocouple
9: external heater
10: pressure gauge
11: flow rate/pressure control device
12: exhaust system
13: fluorine removal device (fluorine gas exhaust means)
14: exhaust pipe (gas exhaust vent)
18: fluoride optical element
20: fluoride optical thin film
21: thermocouple insert pipe
24: thermocouple
25: electrolytic cell
26: hydrogen gas
27: cathode
28: diaphragm
29: direct-current voltage source
30: insulator
31: fluorine gas
32: anode
33: electrolyte
34: plasma chamber
35: tetrafluoromethane gas
36: anode
37: earth
38: earth
39: high-frequency electric source
40: blocking condenser
41: insulator
42: cathode
43: gas containing fluorine (F)
44: plasma
45: ArF laser oscillator
46: chamber
47: ArF laser beam path
48: open/close shutter
49: optical element
50: waveguide
51: entrance side fluoride window
52: optical element support
54: optical thin film
56: exit side fluoride window
58: waveguide
60: open/close shutter
62: joule meter
64: gas introduction pipe
66: open/close valve
68: gas exhaust pipe
70: open/close valve

DETAILED DESCRIPTION OF THE INVENTION

The present invention is described in detail hereinafter.

Fluorination treatment apparatus

The fluorination treatment apparatus of the invention comprises a fluorine gas storage/feed vessel for storing and feeding a fluorine gas, a reactor for bringing a substance to be treated into contact with a fluorine gas (fluorine type gas) to carry out fluorination reaction, and a fluorine gas pipe arranged between the fluorine gas storage/feed vessel and the reactor.

First, the fluorination treatment apparatus in an embodiment of the invention is described below with reference to Fig. 1. The embodiment of the invention is explained below using a case where fluorination treatment of a fluoride optical element is carried out using, as the substance to be treated, a fluoride optical element having a fluoride thin film laminated thereon.

Fig, 1 is a constitutional view of a fluorination treatment apparatus in an embodiment of the invention. Referring to Fig. 1, numeral 1 designates a fluorine gas storage/feed vessel manufactured from Monel alloy of a nickel-copper alloy. To the fluorine gas storage/feed vessel 1, one end of a gas pipe (fluorine gas pipe) 3 made of Monel alloy is connected. To the other end of the gas pipe 3, a reactor 5 is connected.

The gas pipe 3 is provided with valves 4-1, 4-2 and 4-3 whose gas contact portions (portions actually brought into contact with a fluorine gas) are nickel-plated, and to the gas pipe 3, a helium gas cylinder 2 to feed a helium gas for diluting a fluorine gas is connected through the valve 4-2. By the control of open/close operations of the valves 4-1, 4-2 and 4-3, a fluorine gas, a helium gas and a fluorine/helium mixed gas are fed to the reactor 5 from the gas storage/feed vessel 1 through the gas pipe 3.

The reactor 5 is manufactured from nickel having a purity of not less than 99%, and inside the reactor 5, an optical element fixture 6 made of nickel having a purity of not less than 99% is provided. To the optical element fixture 6, a fluoride optical element 7 is fixed. The fluoride optical element 7 used herein is an optical element in which a fluoride solid is coated with a fluorine-deficient fluoride optical thin film. At the top of the reactor 5, a temperature-measuring thermocouple 8 is provided. On each periphery of the fluorine gas storage/feed vessel 1 and the reactor 5, a PID-controllable external heater 9 is provided.

To the reactor 5, one end of an exhaust pipe 14 is connected, and to the exhaust pipe 14, a valve 4-4, a pressure gauge 10 to constitute the exhaust system, a flow rate/pressure control device 11 and a fluorine removal device 13 are connected. Of the exhaust pipe 14, a portion between 0the reactor 5 and the valve 4-4 is made of Monel alloy, and the gas contact portion of the valve 4-4 is nickel-plated.

In this fluorination treatment apparatus, the fluorine gas storage/feed vessel 1 is manufactured from Monel alloy of a nickel-copper alloy; of the gas pipe 3 and the exhaust pipe 14, portions between the reactor 5 and the valve 4-4 are made of Monel alloy; the gas contact portions of the valves 4-1, 4-2 and 4-3 are nickel-plated; and the reactor 5 and the optical element fixture 6 are manufactured from nickel having a purity of not less than 99%.

In the fluorination treatment apparatus of the invention, at least a portion to be brought into contact with a fluorine gas, namely, the whole portion to be brought into contact with a fluorine gas in the region from the fluorine gas storage/feed vessel 1 to the valve 4-4, is constituted of a material having chromium and/or titanium concentration of not more than 1%, preferably not more than 1000 ppm, more preferably not more than 100 ppm. The material of the portion to be brought into contact with a fluorine gas is preferably at least one of nickel, a nickel alloy, copper, a copper alloy, aluminum and an aluminum alloy.

In the fluorination treatment apparatus in this embodiment, the fluorine gas storage/feed vessel 1, the gas pipe 3, the reactor 5 and the optical element fixture 6 are each constituted of a material having a chromium concentration of not more than 1% and a titanium concentration of not more than 1%, but of the fluorine gas storage/feed vessel 1, the gas pipe 3, the reactor 5 and the optical element fixture 6, at least a portion actually brought into contact with a fluorine gas has only to be constituted of a material having a chromium concentration of not more than 1% and a titanium concentration of not more than 1%.

According to the fluorination treatment apparatus of the invention, by carrying out the fluorination treatment, fluorine deficiency of the substance to be treated can be compensated and impurities are decreased, so that the substance to be treated can be converted into a fluoride of stoichiometric composition, and hence the light absorption loss in the vacuum ultraviolet region and the ultraviolet region can be reduced. By carrying out the fluorination treatment using the fluorination treatment apparatus of the invention, further, crystalline properties of the substance to be treated can be enhanced and the structural defects are decreased. By carrying out the fluorination treatment using the fluorination treatment apparatus of the invention, furthermore, laser beam resistance of the substance to be treated can be enhanced.

Process for producing fluorination treated substance

The process for producing a fluorination treated substance according to the invention comprises an enclosure step of enclosing a substance to be treated in a reactor, and a fluorination reaction step of introducing a fluorine type gas into the reactor to bring the substance to be treated into contact with the fluorine type gas and thereby carry out fluorination reaction.

The process for producing a fluorination treated substance according to the invention may have steps other than the enclosure step and the fluorination reaction step. For example, the process of the invention may comprise the enclosure step, a water content exhaust step of exhausting water content from the reactor, the fluorination reaction step, a heat treatment step of heating the substance to be treated which has been enclosed in the reactor, to the prescribed temperature, a cooling step of cooling the substance to be treated which has been enclosed in the reactor, and a withdrawal step of withdrawing the treated substance from the reactor.

When the process for producing a fluorination treated substance according to the invention comprises the enclosure step, the water content exhaust step, the fluorination reaction step, the cooling step and the withdrawal step, the treating temperature in the water content exhaust step is in the range of preferably 100 to 170°C, the temperature in the reactor in the fluorination reaction step is in the range of usually 10 to 500°C, preferably 10 to 150°C, and the fluorine concentration in the reactor in the fluorination reaction step is in the range of usually 10 ppm to 100%, preferably 1000 ppm to 100%.

When the process for producing a fluorination treated substance according to the invention comprises the enclosure step, the water content exhaust step, the fluorination reaction step, the heat treatment step, the cooling step and the withdrawal step, the temperature in the reactor in the fluorination reaction step is in the range of usually 10 to 500°C, preferably 10 to 150°C, the fluorine concentration in the reactor in the fluorination reaction step is in the range of 10 ppm to 100%, preferably 1000 ppm to 100%, the temperature in the reactor in the heat treatment step is preferably higher than the temperature in the reactor in the fluorination reaction step, and the fluorine concentration in the reactor in the heat treatment step is preferably lower than the fluorine concentration in the reactor in the fluorination reaction step.

In the process for producing a fluorination treated substance according to the invention, the fluorination reaction step preferably has a pressure control step of controlling the total pressure and the fluorine partial pressure in the reactor to the prescribed pressures, and a temperature control step of controlling the temperature in the reactor to the prescribed temperature. In the process for producing a fluorination treated substance according to the invention, it is also preferable that the steps other than the fluorination reaction step have the pressure control step and the temperature control step.

In the present invention, the total pressure in the reactor in the fluorination reaction step is in the range of 0.01 MPa to 1.0 MPa, preferably 0.01 MPa to 0.2 MPa, and for example, the pressure (total pressure) in the reactor in the fluorination reaction step can be set at about atmospheric pressure (0.1 MPa).

In the process for producing a fluorination treated substance according to the invention, it is preferable to use the aforesaid fluorination treatment apparatus of the invention.

In the process for producing a fluorination treated substance according to the invention, the substance to be treated is preferably any one of a fluoride thin film, a fluoride powder, a fluoride solid and a fluoride optical element. Such a substance to be treated is desirably a fluoride capable of forming a fluoride optical element. More specifically, the substance to be treated is preferably at least one material selected from the group consisting of magnesium fluoride, calcium fluoride, lithium fluoride, lanthanum fluoride, aluminum fluoride, neodymium fluoride, gadolinium fluoride, yttrium fluoride, dysprosium fluoride, barium fluoride, sodium fluoride, bismuth fluoride, strontium fluoride, lead fluoride, selenium fluoride, cryolite and chiolite.

The fluorine type gas used in the process for producing a fluorination treated substance according to the invention is preferably at least one gas selected from the group consisting of a pure fluorine gas; a fluorine gas diluted with at least one rare gas of helium, neon, argon, krypton and xenon; a gas containing fluorine atoms released during the treatment from the inner surface of the reactor having been previously fluorinated; a gas containing fluorine atoms released during the treatment from a previously fluorinated metal, a fluorine-excess alloy or a fluorine-excess fluoride placed in the reactor; a fluorine gas generated by electrolysis of a metallic fluoride; a gas obtained by sublimating or evaporating a fluorine-rare gas compound of $XeF_2$, $XeF_4$ or $XeF_6$ and a fluorine gas generated by decomposition of the fluorine-rare gas compounds; and a gas containing active fluorine of fluorine radical or fluorine ion generated by dissociating at least one of a carbon-fluorine compound, a sulfur-fluorine compound and a nitrogen-fluorine compound.

The process for producing a fluorination treated substance in an embodiment of the invention is described below with reference to Fig. 1. The embodiment of the invention is explained below using a case where fluorination reaction of a fluoride optical element is carried out using the aforesaid fluorination treatment apparatus of the embodiment of the invention and using, as the substance to be treated, a fluoride optical element having a fluoride thin film formed thereon.

In this embodiment, the fluoride thin film formed on the fluoride optical element used as the substance to be treated is constituted of at least one material selected from the group consisting of magnesium fluoride, calcium fluoride, lithium fluoride, lanthanum fluoride, aluminum fluoride, neodymium fluoride, gadolinium fluoride, yttrium fluoride, dysprosium fluoride, barium fluoride, sodium fluoride, bismuth fluoride, strontium fluoride, lead fluoride, selenium fluoride, cryolite and chiolite.

As the fluorine type gas fed from the fluorine gas storage/feed vessel 1, preferably used is at least one gas selected from the group consisting of a pure fluorine gas; a fluorine gas diluted with at least one rare gas of helium, neon, argon, krypton and xenon; a gas containing fluorine atoms released during the treatment from the inner surface of the reactor having been previously fluorinated; a gas containing fluorine atoms released during the treatment from a previously fluorinated metal, a fluorine-excess alloy or a fluorine-excess fluoride placed in the reactor; a fluorine gas generated by electrolysis of a metallic fluoride; a gas obtained by sublimating or evaporating a fluorine-rare gas compound of $XeF_2$, $XeF_4$ or $XeF_6$ and a fluorine gas generated by decomposition of the fluorine-rare gas compounds; and a gas containing active fluorine of fluorine radical or fluorine ion generated by dissociating at least one of a carbon-fluorine compound, a sulfur-fluorine compound and a nitrogen-fluorine compound.

Next, the process for producing a fluorination treated substance using the aforesaid fluorination treatment apparatus and using, as the substance to be treated, a fluoride optical element coated with a fluorine-deficient fluoride thin film is described. The inner wall of the reactor 5 and the optical element fixture 6 are passivated in advance by introducing a fluorine gas into the reactor 5 and heating the reactor 5 to fluorinate them and thereby deposit nickel fluoride on their surfaces.

In this embodiment, the production of a fluorination treated substance is carried out through a first step of enclosing a substance to be treated, a second step of exhausting water content from the reactor, a third step of fluorination reaction treatment, a fourth step of heat treatment, a fifth step of cooling and a sixth step of withdrawal of the treated substance.

In the first step (enclosure of a substance to be treated), a fluoride optical element 7 having a fluoride thin film formed in advance is prepared. After the fluoride optical element 7 is cleaned, it is fixed to the optical element fixture 6 in the reactor 5.

In the second step (exhaust of water content from the reactor), the gas in the reactor 5 is exhausted to $10^{-5}$ Pa by means of the exhaust system 12, then with introducing a helium gas into the reactor 5 through the gas pipe 3, the temperature in the reactor 5 is raised up to 150°C by the use of the external heater 9, and the reactor 5 is held in this state for 12 hours to exhaust water content. For the temperature measurement, the temperature-measuring thermocouple 8 is used. In the water content exhaust step, the temperature in the reactor 5 may be in the range of 100 to 170°C.

In the third step (fluorination reaction treatment), the temperature in the reactor 5 is set at 100°C, and the fluorine gas fed from the fluorine gas storage/feed vessel 1 is diluted to a desired concentration (1000 ppm to 100%) with a helium gas and introduced into the reactor 5 through the gas pipe 3 and the valve 4-3 to promote fluorination reaction. By the use of the flow rate/pressure control device 11 arranged on the downstream side of the reactor 5, the pressure is so controlled that the indicated values of the pressure gauge 10 become the desired values (prescribed total pressure and fluorine partial pressure), and the timing is started. In this step, the reactor may be an open reactor wherein the exhaust system is opened to continuously let the gas flow or a closed reactor wherein the exhaust system is closed to stop the gas flow. During the fluorination reaction, the temperature in the reactor 5 is maintained constant at 100°C. In this state, a given period of time is allowed to pass. In the fluorination reaction step, the temperature in the reactor 5 may be in the range of 10 to 150°C.

In the fourth step (heat treatment), the fluorine gas in the reactor 5 is temporarily exhausted and replaced with a helium gas. Then, the fluorine gas fed from the fluorine gas storage/feed vessel 1 is again diluted to a desired concentration with a helium gas and introduced into the reactor 5 through the gas pipe 3 and the valve 4-3. The concentration of the dilute fluorine gas introduced into the reactor 5 in this step is made lower than that of the dilute fluorine gas in the third step (fluorination reaction treatment). The temperature in the reactor 5 is raised up to 300°C, i.e., temperature higher than the temperature in the reactor 5 in the fluorination reaction step. After a temperature of 300°C is reached, by the use of the flow rate/pressure control device 11 arranged on the downstream side of the reactor 5, the pressure is so controlled that the indicated value of the pressure gauge 10 becomes a desired value, and the timing of the heat treatment is started. In this step, the reactor may be an open reactor wherein the exhaust system is opened to continuously let the gas flow or a closed reactor wherein the exhaust system is closed to stop the gas flow. During the heat treatment, the temperature in the reactor 5 is maintained constant at 300°C. In this state, a given period of time is allowed to pass.

In the fifth step (cooling), heating of the reactor 5 is stopped, and cooling of the reactor 5 is started with keeping the same fluorine concentration as that in the fourth step (heat treatment). When the temperature in the reactor 5 is lowered to 150°C, introduction of the dilute fluorine gas is stopped, and the gas in the reactor 5 is exhausted and replaced with a helium gas. When the temperature in the reactor 5 is lowered to room temperature, cooling is finished.

In the cooling step, the reactor may be an open reactor wherein the exhaust system is opened to continuously let the gas flow or a closed reactor wherein the exhaust system is closed to stop the gas flow.

In the sixth step (withdrawal of the substance), replacement with the helium gas is stopped, and the reactor 5 is opened to withdraw the substance which has been subjected to the fluorination reaction (fluorination heat treatment).

In this embodiment, through the third step (fluorination reaction), the substance to be treated is freed of oxygen, hydroxyl group and other impurities and fluorinated, or the fluorine-deficient portions of the substance to be treated are completely fluorinated, whereby a fluoride of stoichiometric composition is obtained.

In the subsequent fourth step (heat treatment), chemical bonding between fluorine and a non-fluorine element is stabilized. Particularly when the substance to be treated is a thin film or a porous substance, the structure of the whole substance is densified by heating to decrease the area exposed to the atmosphere, so that deterioration caused by the reaction with water or the like when exposed to the atmosphere after the treatment can be reduced.

In this embodiment, the time for the fluorination reaction step and the time for the heat treatment step have only to be those enough to diffuse fluorine into the prepared thin film or powder at the selected fluorine gas pressure and the selected treating temperature. From the experiments heretofore made, it has been found that the time for each of those steps has only to be about 1 hour. In the substance having passed through the first to the sixth steps, i.e., in the fluorination treated substance produced by the process of the invention, the fluorine deficiency has been compensated and the impurities have been decreased, that is, the substance has been converted into a fluoride of stoichiometric composition. Further, the resulting substance is a substance enhanced in the crystalline properties, decreased in the structural defects and enhanced in the laser beam resistance.

In this embodiment, a case where fluorination reaction (fluorination heat treatment) of a fluoride optical element is carried out using, as the substance to be treated, a fluoride optical element having a fluoride thin film formed thereon is described. However, fluorination reaction (fluorination heat treatment) of a fluoride thin film, a fluoride powder or a fluoride solid may be carried out using, as the substance to be treated, a fluoride thin film, a fluoride powder or a fluoride solid.

According to the present invention, by carrying out fluorination reaction (fluorination heat treatment), fluorine deficiency of the substance to be treated can be compensated and impurities are decreased, whereby the substance to be treated can be converted into a fluoride of stoichiometric composition. By carrying out fluorination reaction (fluorination heat treatment), further, crystalline properties of the substance to be treated can be enhanced and the structural defects can be decreased. Consequently, the optical absorption edge wavelength is shifted to the shorter wavelength side and approaches that of the ideal crystal, and the absorption attributable to the defects or the impurities is reduced. Hence, the transmittance in the vacuum ultraviolet region is increased, and the laser beam resistance is enhanced.

<u>Fluorination treatment (cleaning) of abraded fluoride optical element</u>

In the invention described above, the substance to be treated is also preferably a fluoride optical element obtained by abrading a surface of a fluoride solid by the use of abrasive grain. In the process for producing a fluorination treated substance in this case, the fluorination reaction step is desirably a step of cleaning a fluoride optical element that is the substance to be treated. That is to say, the process for producing a fluorination treated substance according to the invention may have (I) a step of abrading a surface of a fluoride solid with abrasive grain to give a fluoride optical element (referred to as a "step (I)" hereinafter) and (II) a step of bringing the fluoride optical element into contact with a fluorine type gas to clean the fluoride optical element (referred to as a "step (II)" hereinafter).

As the fluoride solid to be subjected to abrasion in the step (I), any of the fluorides capable of forming a fluoride optical element previously described as the substance to be treated is preferably employed.

The fluoride solid used in the step (I) is a fluoride solid roughly shaped into a desired optical element, which is usually obtained by cutting a starting fluoride, grinding it and roughly abrading it, and the abrasion in the step (I) corresponds to precision abrasion (final abrasion). In the step (I), surface abrasion of the fluoride solid is carried out usually using a suspension in which abrasive grains are dispersed in a solvent such as water.

Examples of generally known materials of the abrasive grains for use in the precision abrasion of the fluoride solid surface include oxides, such as silicon dioxide, aluminum oxide, chromium oxide, zirconium oxide and cerium oxide, carbides, such as silicon carbide and boron carbide, cubic boron nitride and diamond.

As the abrasive grain for use in the step (I) of the invention, any material which reacts with the fluorine type gas to form a compound of high volatility is employable, but preferable is at least one material selected from the group consisting of silicon dioxide ($SiO_2$), silicon carbide (SiC), boron carbide ($B_4C$), cubic boron nitride (BN) and diamond (C). Of these, silicon dioxide that is excellent in the property values such as hardness is particularly preferable as the abrasive grain for the precision abrasion (final abrasion) of the fluoride optical element material.

After the fluoride optical element obtained in the step (I) is cleaned by a conventional cleaning method, on the surface of the fluoride optical element are present abrasive grains sticking thereinto or a work-modification layer formed by the chemical reaction.

It is very difficult to remove the abrasive grains sticking into the surface or the work-modification layer formed on the surface and to obtain a fluoride optical element having a clean surface. However, if the fluorination reaction sufficiently proceeds in the step (II) that follows the step (I), it becomes possible to remove them by chemical etching because a substance of high volatility is formed by the reaction with the fluorine type gas as indicated by, for example, the following reaction formulas <1> to <5>.

$$SiO_2 + 2F_2 \rightarrow SiF_{4\uparrow} + O_{2\uparrow} \qquad \langle 1\rangle$$

$$SiC + 4F_2 \rightarrow SiF_{4\uparrow} + CF_{4\uparrow} \qquad \langle 2\rangle$$

$$B_4C + 8F_2 \rightarrow 4BF_{3\uparrow} + CF_{4\uparrow} \qquad \langle 3\rangle$$

$$BN + 3/2F_2 \rightarrow BF_{3\uparrow} + 1/2N_{2\uparrow} \qquad \langle 4\rangle$$

$$C + 2F_2 \rightarrow CF_{4\uparrow} \qquad \langle 5\rangle$$

It is undesirable to use abrasive grains of a material that forms a compound of low volatility by the reaction with the fluorine type gas, such as aluminum oxide, zirconium oxide or cerium oxide, because the residual abrasive grains are not sufficiently removed in the step (II).

For example, on the surface of a fluoride optical element obtained by conducting the step (I) using abrasive grains of aluminum oxide (alumina ($Al_2O_3$)) and then conducting conventional cleaning, there are present aluminum oxide abrasive grains sticking thereinto or a work-modification layer formed by the chemical reaction of aluminum oxide with a fluoride. In this case, even if the fluorination reaction of the fluoride optical element sufficiently proceeds in the subsequent step (II), it is difficult to remove aluminum that is the residual element. The reason is that since aluminum fluoride which is a reaction product of the abrasive grain sticking into the fluoride optical element surface or the work-modification layer formed on the surface with the fluorine type gas has low volatility, the aluminum fluoride cannot be removed from the fluoride optical element surface, as indicated by, for example, the following reaction formula <6>.

$$Al_2O_3 + 3F_2 \rightarrow 2AlF_3 + 3/2O_{2\uparrow} \qquad \langle 6\rangle$$

If the abrasive grains of aluminum oxide are selected as described above, aluminum fluoride that is a reaction product remains on the fluoride optical element surface. It can be thought that the aluminum fluoride remaining on the fluoride optical element surface is present in the state of firmly adhering or sticking into the fluoride optical element surface or in the state of a work-modification layer formed by the chemical reaction with the fluoride optical element surface. Since the aluminum fluoride itself is transparent in the vacuum ultraviolet region, it is presumed that the light absorption loss of the fluoride optical element surface is decreased by the step (II), but actually, aluminum fluoride is a chemically unstable substance, so that by the reaction with oxygen or water content in the atmosphere, it is converted into aluminum oxide or aluminum hydroxide which absorbs vacuum ultraviolet light, and as a result, the light absorption loss is sometimes increased.

Also when abrasive grains of zirconium oxide or cerium oxide are used, it is difficult to sufficiently remove the abrasive grains remaining in the step (I) or the work-modification layer in the step (II) because of low volatility of zirconium fluoride or cerium fluoride that is a reaction product with a fluorine type gas, similarly to the case of using aluminum oxide. On this account, it is undesirable to select, as abrasive grain, a material that forms a compound of low volatility by the reaction with a fluorine type gas.

In the step (II), the fluoride optical element having been surface abraded in the step (I) is brought into contact with a fluorine type gas to perform fluorination reaction. Through the fluorination reaction, a component derived from trace amounts of the abrasive grains remaining on the fluoride optical element surface is allowed to sufficiently react with the fluorine type gas to form a fluoride of high volatility, whereby the component derived from the abrasive grains is removed from the fluoride optical element surface, that is, cleaning of the fluoride optical element is carried out.

The fluorine type gas used in the step (II) is a gas containing fluorine (F). As the fluorine type gas for the fluorination reaction, any of the aforesaid gases is employable, but preferable is a gas containing a fluorine gas (F2). Further, a fluorine gas atmosphere having high reactivity, e.g., a gas containing active fluorine such as fluorine radical or fluorine ion, can be selected. More specifically, it is preferable to select and use, as the fluorine type gas, a fluorine gas; carbon fluoride, such as tetrafluoromethane; sulfur fluoride, such as sulfur hexafluoride; nitrogen fluoride, such as nitrogen trifluoride; metallic fluoride, such as manganese tetrafluoride or silver difluoride; hydrogen fluoride; halogen fluoride, such as chlorine trifluoride; or a gas atmosphere containing fluorine generated by dissociating a fluorine-containing compound containing at least one of fluorides of rare gases, such as xenon difluoride, by the use of any one of heat, electricity and plasma. It is also preferable to dilute such a fluorine type gas with a gas which does not react with the component derived from the abrasive grains, such as rare gas, prior to use.

In the step (II), the temperature for contacting the fluoride optical element with the fluorine type gas is in the range of 10 to 500°C, preferably 50 to 400°C.

In the step (II), the elements derived from the abrasive grains remaining on the surface of the fluoride optical element react with the fluorine type gas, and they are removed as volatile matters from the surface of the fluoride optical element, whereby the abrasive grains sticking into the surface and the work-modification layer are favorably removed from the fluoride optical element surface, though they cannot be removed by physical cleaning. As a result, the light absorption loss attributable to the abrasive grains or the work-modification layer is markedly decreased, and a fluoride optical element having more excellent optical properties can be obtained as a fluorination treated substance.

In the fluoride optical element obtained as above, the light absorption loss of the optical element surface attributable to the abrasive grains or the work-modification layer is small, and the optical element exhibits high transmission particularly to the light of short wavelength. By the fluorination reaction, the light absorption loss of the fluoride optical element surface at 157 nm is decreased by usually not less than 0.1%, and the optical element exhibits excellent optical properties.

The step (II) can be preferably carried out using the aforesaid fluorination treatment apparatus of the invention. One example of the step (II) is described below with reference to Fig. 1, though the invention is in no way limited to the example. In the below-described step (II), a fluoride optical element obtained by molding a fluoride solid into an optical element shape, then precisely abrading it with abrasive grains and cleaning it by a conventional cleaning method using a surface active agent and water, namely, a fluoride optical element obtained in the aforesaid step (I), is used as the fluoride optical element designated by numeral 7 in Fig. 1.

Fig. 1 shows an example of constitution of a fluorination treatment apparatus (cleaning apparatus) capable of performing the step (II), i.e., fluorination reaction step wherein the fluoride optical element surface that is a substance to be treated is brought into contact with a fluorine type gas and cleaned. Referring to Fig. 1, numeral 1 designates a fluorine gas generation source manufactured from nickel; numeral 2 designates a helium gas cylinder for diluting a fluorine gas; numeral 3 designates a Monel-made gas pipe for feeding a fluorine gas, a helium gas and a fluorine/helium mixed gas; numeral 4 designates a valve whose gas contact portion is nickel-plated; numeral 5 designates a reactor (cleaning vessel) manufactured from nickel; numeral 6 designates a fixture for a fluoride optical element, which is made of nickel; numeral 7 designates a fluoride optical element; numeral 8 designates a temperature-measuring thermocouple; numeral 9 designates a PID-controllable external heater; numeral 10 designates a pressure gauge; numeral 11 designates a flow rate/pressure control means; numeral 12 designates an exhaust system; numeral 13 designates a fluorine gas exhaust means; and numeral 14 designates an exhaust pipe.

It is desirable that the inner wall of the reactor (cleaning vessel) 5 and the fixture for a fluoride optical element are passivated in advance by introducing a fluorine gas into the reactor (cleaning vessel) and heating the reactor (cleaning vessel) to fluorinate them and thereby deposit nickel fluoride on their surfaces.

The material of each of the inner wall of the cleaning vessel, the inner wall of the gas pipe and the gas contact portion of the valve is preferably at least one of nickel, a nickel alloy, copper, a copper alloy, aluminum and an aluminum alloy and has each of a chromium concentration and a titanium concentration of not more than 1%, preferably not more than 1000 ppm, more preferably not more than 100 ppm.

The fluorination treatment (fluorine cleaning) of the fluoride optical element after the abrasion is carried out by continuous four steps consisting of a step of enclosing a fluoride optical element, a step of exhausting water content from a cleaning vessel, a fluorination reaction step and a step of withdrawing a fluoride optical element. The step of exhausting water content from a cleaning vessel may be omitted, but the step of enclosing a fluoride optical element, the fluorination reaction step and the step of withdrawing a fluoride optical element are essential. These steps are described below in detail.

In the step of enclosing a fluoride optical element, the fluoride optical element 7 having been subjected to precision abrasion (final abrasion) with a suspension in which abrasive grains of at least one material selected from the group consisting of silicon dioxide, silicon carbide, boron carbide, cubic boron nitride and diamond are dispersed and then subjected to conventional cleaning is fixed to the fluoride optical element fixture 6 in the cleaning vessel (reactor) 5, and then the cleaning vessel 5 is closed.

In the step of exhausting water content from a cleaning vessel, the gas in the cleaning vessel 5 is exhausted

to $10^{-5}$ Pa by means of the exhaust system 12, then with introducing a helium gas into the cleaning vessel 5 through the gas pipe 3, the temperature in the cleaning vessel 5 is raised up to 150°C by the use of the external heater 9, and the cleaning vessel 5 is held in this state for 12 hours to exhaust water content. For the temperature measurement, the thermocouple 8 is used. The water content exhaust step is effective for preventing corrosion deterioration of the inner wall of the cleaning vessel 5. Since the cleaning effect on the abraded surface of the fluoride optical element is not lowered even if the water content exhaust step is not conducted, it is possible to omit this water content exhaust step.

In the fluorination reaction step wherein the surface-abraded fluoride optical element 7 is brought into contact with a fluorine type gas, the fluorine gas fed from the fluorine gas generation source 1 is diluted to a concentration of about 1% with a helium gas and introduced into the cleaning vessel 5 through the gas pipe 3 and the valve 4. The temperature of the gas atmosphere in the cleaning vessel 5 is set at 100°C to promote the fluorination reaction on the abraded surface of the fluoride optical element. By the use of the flow rate/pressure control device 11 arranged on the downstream side of the cleaning vessel 5, the pressure is so controlled that the indicated value of the pressure gauge 10 becomes 0.1 MPa (atmospheric pressure), and the timing is started. In this step, the cleaning vessel may be an open cleaning vessel wherein the exhaust system is opened to continuously let the gas flow or a closed cleaning vessel wherein the exhaust system is closed to stop the gas flow. In this state, a given period of time is allowed to pass. In the fluorination reaction step, the conditions have only to be those under which fluorination reaction proceeds on the abraded surface of the fluoride optical element, and the temperature of the gas atmosphere in the cleaning vessel 5, i.e., temperature for contacting the fluoride optical element with the fluorine type gas, is in the range of 10 to 500°C, preferably 50 to 400°C, more preferably 100 to 300°C. If the temperature is lower than 10°C, the rate of fluorination reaction is slow and the cleaning efficiency is lowered. If the temperature exceeds 500°C, a problem that the material of the inner wall of the cleaning vessel 5 or the fluoride optical element fixture 6 is corroded and deteriorated may occur. As the fluorine gas concentration, an arbitrary concentration of 1 ppm to 100% can be selected. As the gas pressure, an arbitrary pressure of $10^{-5}$ to $10^{-7}$ Pa can be selected. The term "given period of time" used herein means a time necessary for sufficiently cleaning the abraded surface of the fluoride optical element, and the time is determined according to the material of the fluoride optical element, the material of the abrasive grain or the abrasion conditions in the precision abrasion (final abrasion) step, and the temperature of the gas atmosphere, fluorine gas concentration and gas pressure in the cleaning vessel 5 in the fluorination reaction step. From the results of the experiments heretofore made, it has been confirmed that, in the case of cleaning after abrasion of a surface of fluorite (calcium fluoride) with silicon dioxide type abrasive grains, if the temperature of the gas atmosphere in the cleaning vessel 5 is 100°C and the fluorine concentration therein is 1%, a period of 1 hour is enough. After a lapse of a given period of time, heating is stopped if the cleaning vessel 5 is heated, and then the cleaning vessel 5 is cooled until the temperature of the fluoride optical element 7 becomes about room temperature.

In the fluorination reaction step, it is preferable to select a fluorine gas atmosphere having high reactivity, and for example, any of those exemplified with respect to the fluorine type gas used for the aforesaid fluorination reaction is employable.

In the step of withdrawing a fluoride optical element, introduction of the fluorine type gas is stopped, and then the gas in the cleaning vessel 5 is exhausted and thoroughly replaced with a helium gas. Thereafter, replacement with the helium gas is stopped, and the cleaning vessel 5 is opened to withdraw the fluoride optical element cleaning of which has been completed.

In the fluorination reaction step, the abrasive grains sticking into the fluoride optical element surface and the work-modification layer are removed by the fluorination reaction, that is, the fluoride optical element surface is cleaned. The surface of the fluoride optical element obtained after the cleaning in the invention becomes a fluoride having the same stoichiometric composition as that of the inside.

In the present invention, when the substance to be treated is a fluoride optical element obtained by surface abrasion, the resulting fluorination treated substance (fluoride optical element) is one obtained by the aforesaid process for producing a fluorination treated substance. Because the elements derived from the abrasive grains are removed as volatile matters from the surface of the fluoride optical element, the light absorption loss attributable to the residual abrasive grains becomes almost zero or extremely small, and the fluoride optical element exhibits high transmission particularly to the light of short wavelength. The light absorption loss of the surface at 157 nm is decreased by usually not less than 0.1%, and the optical element exhibits excellent optical properties.

The light absorption loss of the surface at 157 nm that is decreased by the fluorination reaction can be calculated in the following manner from the results of vacuum ultraviolet spectrometry.

The light absorption loss $L_{157nm}$% of the optical element at 157 nm is represented by the formula (A).

$$L_{157nm} = (\text{surface absorption loss at 157 nm}) \times 2 + (\text{inside absorption loss at 157 nm}) \qquad (A)$$

The surface absorption loss occurs on two surfaces of the light entrance side surface and the light exit side surface.

On the other hand, the transmittance ($T_{157nm}$, %) and the reflectance ($R_{157nm}$, %) of the optical element at 157 nm can be measured by a vacuum ultraviolet spectrometer, so that the light absorption loss $L_{157nm}(I)$% of the optical element at 157 nm after the step (I) and the light absorption loss $L_{157nm}(II)$% thereof after the step (II) are determined by the formulas (B) and (C), respectively.

$$L_{157nm}(I) = 100 - T_{157nm}(I) - R_{157nm}(I) \qquad (B)$$

$$L_{157nm}(II) = 100 - T_{157nm}(II) - R_{157nm}(II) \qquad (C)$$

In the above formulas, $T_{157nm}(I)$ and $R_{157nm}$ (I) represent a transmittance and a reflectance, respectively, of the optical element at 157 nm after the step (I), and $T_{157nm}$ (II) and $R_{157nm}$ (II) represent a transmittance and a reflectance, respectively, of the optical element at 157 nm after the step (II).

Since it can be thought that the inside absorption loss at 157 nm is not changed by the fluorination reaction of the invention, the light absorption loss $\Delta L_{157nm}$% of the surface at 157 nm that is decreased by the fluorination reaction is calculated from the formula (D).

$$\Delta L_{157nm} = [L_{157nm}(I) - L_{157nm}(II)]/2 \qquad (D)$$

As described above, when the substance to be treated is a fluoride optical element obtained by surface abrasion, the abrasive grains sticking into the fluoride optical element surface and the work-modification layer formed by the chemical reaction of the fluoride optical element surface with the abrasive grains can be efficiently removed by the process for producing a fluorination treated substance according to the invention. Further, a fluoride optical element having a smooth and clean surface of the same composition as that of the inside and having very small light absorption loss of the surface to the light of short wavelength can be readily and efficiently produced. The fluoride optical element obtained by this process, i.e., a fluorination treated substance of the invention, has a smooth and clean surface and has very small light absorption loss to the light of short wavelength, so that this fluoride optical element can be favorably used as an optical element particularly for the vacuum ultraviolet region.

<u>Densification of fluoride optical thin film</u>

In the present invention, the substance to be treated is also preferably a fluoride optical element having a fluoride optical thin film laminated thereon. In this case, the fluorination reaction step is desirably a step of densifying the fluoride optical thin film by heating.

In this case, the process for producing a fluorination treated substance is preferably a process for producing a fluorination treated substance (process for densifying a fluoride optical thin film), comprising:

an enclosure step of enclosing, as a substance to be treated, a fluoride optical element having a fluoride optical thin film laminated thereon in a reactor,
a fluorination reaction step (densification step) comprising introducing a fluorine type gas into the reactor and heating the fluoride optical thin film to densify the film,
a cooling step of cooling the fluoride optical element which has been enclosed in the reactor, and
a withdrawal step of withdrawing the fluoride optical element from the reactor,

wherein the temperature in the reactor in the fluorination reaction step (densification step) is in the range of 200 to 400°C, and the fluorine gas concentration in the reactor in the this step is in the range of 10 ppm to 100%.

According to the process of the invention for producing a fluorination treated substance wherein a fluoride optical thin film is densified, fluorine deficiency of the fluoride optical thin film laminated on the fluoride optical element can be compensated and the fluoride optical thin film can be densified. Consequently, there can be minimized a lowering of transmittance (cloudiness) of the fluoride optical thin film, said lowering being brought about by adsorption or polymerization of a volatile organic matter or a volatile inorganic matter remaining in the mirror tube in the semiconductor exposure apparatus enclosing the optical element.

Further, the fluoride optical element (fluorination treated substance) obtained as above has a fluoride optical thin film whose pores capable of being invaded by water vapor, a volatile organic matter and a volatile inorganic matter are closed by the above-mentioned process for producing a fluorination treated substance (process for densifying a fluoride optical thin film).

The fluoride optical element has a fluoride optical thin film which is capable of minimizing a lowering of transmittance (cloudiness) brought about by adsorption or polymerization of a volatile organic matter or a volatile inorganic matter on the fluoride optical thin film because the pores capable of being invaded by water vapor, a volatile organic matter and a volatile inorganic matter are closed to thereby densify the fluoride optical thin film.

Next, the process for producing a fluorination treated substance (process for densifying a fluoride optical thin film) in an embodiment of the invention is described with reference to Fig. 2.

Fig. 2 is a constitutional view of a fluorination treatment apparatus (apparatus for densifying optical thin film) in an embodiment of the present invention in the case where the substance to be treated is a fluoride optical element having a fluoride optical thin film laminated thereon. The densification apparatus has a reactor (treatment vessel) 5 having a cylindrical inner space for enclosing an optical element having an optical thin film. Around the reactor (treatment vessel) 5, an external heater 9 is arranged. On the bottom of the reactor (treatment vessel) 5, a gas inlet 3 and a valve 4 for opening or closing a gas inlet 3 are provided. At the top of the reactor (treatment vessel) 5, a gas exhaust vent 14, a valve 4 for opening or closing the gas exhaust vent 14 and a flow rate/pressure control device 11 for controlling the flow rate of the exhaust gas and controlling the pressure inside the reactor (treatment vessel) 5 are provided.

In the inner space of the reactor (treatment vessel) 5, plural optical element fixtures (supports) 6 for supporting optical elements are provided, and a fluoride optical element 18 made of fluorite is supported on each optical element support 6. On the fluoride optical element 18, a fluoride optical thin film 20 is laminated. In the vicinity of each optical element support 6 in the reactor (treatment vessel) 5, a thermocouple insert pipe 22 made of nickel is provided, and into the thermocouple insert pipe 22, a thermocouple 24 for measuring a temperature of the fluorine gas atmosphere in the reactor (treatment vessel) 5 is inserted.

Next, the process for densifying a fluoride thin film using the optical thin film densification apparatus is described. The material of the reactor (treatment vessel) 5 is nickel, and the material of each of the valve 4 and the gas pipe is Monel of a nickel-copper alloy. The material of each of the inner wall of the reactor (treatment vessel) 5, the inner wall of the gas pipe and the gas contact portion of the valve 4 has only to be at least one of nickel, a nickel alloy, copper, a copper alloy, aluminum and an aluminum alloy, and has each of a chromium concentration and a titanium concentration of not more than 1%, preferably not more than 1000 ppm, more preferably not more than 100 ppm.

In the first step (enclosure step) of the process for densifying an optical thin film, a fluoride optical element 18 on which a fluoride optical thin film 20 is formed in advance is prepared. The fluoride optical element 18 is cleaned and then fixed to the optical element support 6 in the reactor (treatment vessel) 5.

In the second step (exhaust step), the gas in the reactor (treatment vessel) 5 is exhausted from the gas exhaust vent 14 by the use of a vacuum pump until the pressure in the reactor (treatment vessel) 5 becomes $10^{-4}$ Pa, then with introducing a helium gas into the reactor (treatment vessel) 5 through the gas inlet 3, the fluoride optical element 18 in the reactor (treatment vessel) 5 is heated to 150°C by the use of the external heater 9, and the reactor (treatment vessel) 5 is held in this state for 12 hours to exhaust water content. For measuring the temperature of the fluoride optical element 18, a thermocouple 24 is used. In the water content exhaust step, the treating temperature can be appropriately selected from the range of 100 to 170°C.

In the third step (densification step, fluorination reaction step), a fluorine gas having been diluted to 10 ppm with a helium gas is introduced into the reactor (treatment vessel) 5. By the use of the flow rate/pressure control device 11, the flow rate of the dilute fluorine gas is so controlled that the pressure in the reactor (treatment vessel) 5 becomes 0.1 MPa, while the temperature in the reactor (treatment vessel) 5 is raised up to 300°C. After a temperature of 300°C is reached, timing of the densification is started, and the temperature and the pressure are made constant at 300°C and 0.1 MPa, respectively. In this densification step, heating is carried out in a fluorine gas atmosphere, so that the fluorine deficiency can be prevented, and the fluoride optical thin film can be burned and thereby densified. In this step, the treatment vessel may be an open treatment vessel wherein the exhaust system is opened to continuously let the gas flow or a closed treatment vessel wherein the exhaust system is closed to stop the gas flow. During the densification step, the temperature in the reactor (treatment vessel) 5 can be appropriately selected from the range of 200 to 400°C, and the fluorine gas concentration can be appropriately selected from the range of 10 ppm to 100%.

In the fourth step (cooling step), heating of the reactor (treatment vessel) 5 is stopped, and cooling of the reactor (treatment vessel) 5 is started with keeping the same fluorine gas concentration as that in the third step. When the temperature in the reactor (treatment vessel) 5 is lowered to room temperature, introduction of the dilute fluorine gas is stopped, and the gas in the reactor (treatment vessel) 5 is exhausted and replaced with a helium gas. During the cooling step, the treatment vessel may be an open treatment vessel wherein the exhaust system is opened to continuously let the gas flow or a closed treatment vessel wherein the exhaust system is closed to stop the gas flow.

In the fifth step (withdrawal step), replacement with the helium gas is stopped, and the reactor (treatment vessel) 5 is opened to withdraw the fluoride optical element 18 that is the substance having been subjected to densification.

According to the invention of this embodiment, there can be provided a fluoride optical element having a fluoride optical thin film capable of minimizing a lowering of transmittance (cloudiness) of the fluoride optical thin film, said lowering being brought about by adsorption or polymerization of a volatile organic matter or a volatile inorganic matter remaining in the mirror tube enclosing the optical element. Therefore, if the fluoride optical element (fluorination treated substance) with a fluoride optical thin film, which is obtained by the process for producing a fluorination treated substance (process for densifying a fluoride optical thin film), is applied to a semiconductor exposure apparatus, there can be inhibited a lowering of transmittance or occurrence of illuminance nonuniformity which takes place when an extremely fine circuit pattern is printed onto a semiconductor wafer in a semiconductor exposure apparatus using ultraviolet KrF excimer laser, deep ultraviolet ArF excimer laser or vacuum ultraviolet $F_2$ laser as an exposure light source. Hence, productivity of the semiconductor exposure apparatus can be remarkably enhanced.

Examples

The present invention is described in more detail with reference to the following non-limiting examples.

<u>Example 1</u>

In this example 1, a fluorination apparatus having a structure as shown in Fig. 1 was used and in a gas pipe 3 and an exhaust pipe 14, as shown in Fig. 1, a monel metal alloy of a nickel-copper alloy was used for a material of a section from a reactor 5 to a valve 4-4. Stainless steel valves 4-1, 4-2, 4-3 and 4-4 were dismantled and gas-contacting portions of the valves were subjected to nickel-plating so that chromium and fluorine were not contacted. By the nickel-plating, the whole fluorine gas feeding system and reaction system were completely chromium free. Samples prepared by film forming each of $MgF_2$ and $LaF_3$ single layer films in a film thickness of 150 nm onto a fluorite substrate were used. In a fluorination reaction step at 100°C, 100% fluorine gas was fed. That is, dilution with helium was not conducted. In a subsequent heating step at 300°C, fluorine gas containing 10 ppm of fluorine prepared by diluting with helium gas was introduced. The total pressure inside the reactor was determined to 0.1 MPa, i.e. atmospheric pressure from the fluorination reaction step to the heating step.

Difference in film loss before and after the fluorination reaction (fluorination with heat) and a chromium concentration detected from the $MgF_2$ film surface after the fluorination reaction were shown in Fig. 3. The optical loss used herein was a value determined by measuring a transmittance T(%) and a reflectance R(%) in a $F_2$ laser wave length (157 nm) and then subtracting them from 100%, i.e. 100 - (T+R) (%). The value of difference in film loss before and after the fluorination reaction is a value determined by subtracting an optical loss before the fluorination reaction from an optical loss after the fluorination reaction. When the value of the difference is negative, this means the fact that the optical loss can be decreased by the fluorination reaction. Contrarily, when the value is positive, this means the fact that the optical loss is increased only by the fluorination reaction. Meanwhile, the chromium concentration was determined by making good use of time of flight secondary ion mass spectrometry (TOF-SIMS), which is suitable for very slight amount elemental analysis.

In any of the $MgF_2$ and $LaF_3$ films, the difference in the film loss had a negative value and the film loss could be successfully decreased vastly by the fluorination reaction. Further, the chromium concentration detected from the $MgF_2$ film surface was slightly 13 ppm. The titanium concentration detected from the $MgF_2$ film surface in the same method as the chromium concentration was 20 ppm. The reason that the chromium concentration and the titanium concentration were detected in Example 1 was that the concentrations of metals other than chromium and titanium were very low and thereby they have no problem.

Next, with regard to the $LaF_3$ film obtained before the fluorination reaction (fluorination with heat) and the $LaF_3$ film obtained after the fluorination reaction with the experimental apparatus of Example 1, the O atom concentration and OH concentration in the direction of a film depth were measured by SISM and the results are shown in Fig. 4. In this measurement, the analysis in the depth direction was carried out while sputtering the film with irradiating plus ions accelerated on the film. The sputtering time in the horizontal axis of the graph meant the depth direction of the film. With prolonging the sputtering time, it indicated information in a deeper position of the film. The sputtering time 0 s indicated in the left end of the graph was namely the film surface, and the sputtering time indicated in the right end of the graph was the deepest position of the film, which was the interface with the substrate. Between before and after the fluorination reaction with heat, the O concentrations and the OH concentrations had no difference only on the film surface (sputtering time 0 s). When the fluorination with heat was applied on the film, the O concentration was lowered to be one tenth as much as that before the fluorination with heat on the whole region of the film inside and the OH concentration was lowered to be one hundredth. The film was completely fluorinated and thereby the concentrations of oxygen and hydroxyl groups, which induce absorption in the vacuum ultraviolet region, could be decreased remarkably as shown in Fig. 4. Therefore, such a remarkable decrease in the film loss could be attained as shown in Fig. 3.

In Example 1, the materials of the valves 4-1, 4-2, 4-3 and 4-4 were changed from mere stainless steel to stainless steel plated with nickel and the nickel-plated stainless steel was used for the gas-contacting parts located inside of the valves so that great results could be obtained. Besides, in place of the valves prepared by using the nickel-plated stainless steel, the use of valves especially prepared by using monel metal alloy, nickel, nickel alloy, aluminum, aluminum alloy, copper or copper alloy attains the same results.

Comparative Examples 1 and 2

In Comparative Example 1, fluorination reaction (fluorination with heat) was carried out using a stainless steel gas pipe and a stainless steel valve in the fluorine gas feed system. In Comparative Example 2, fluorination with heat was carried out by changing a material of a gas pipe from stainless steel to monel metal alloy and only using a stainless steel valve (in this case, the stainless steel had a chromium concentration of 18 %) in the fluorine gas feed system. In Comparative Examples 1 and 2, samples prepared by film forming each of $MgF_2$ and $LaF_3$ single layer films in a film thickness of 150 nm onto a fluorite substrate were used. In a fluorination reaction step at 100°C, 100% fluorine gas was introduced. That is, dilution with helium was not conducted. In a subsequent heating step at 300°C, fluorine gas containing 10 ppm of fluorine prepared by diluting with helium gas was introduced. The total pressure inside the reactor was set to 0.1 MPa, i.e. atmospheric pressure from the fluorination reaction step to the heating step.

Difference in optical loss of each of the $MgF_2$ and $LaF_3$ films before and after the fluorination with heat and a chromium concentration detected from the $MgF_2$ film surface after the fluorination with heat were shown in Fig. 3.

In results, as is clear from Fig. 3, in both of Comparative Examples 1 and 2, the optical loss of each of the samples with the $MgF_2$ and $LaF_3$ films did not decrease. It rather increased. However, in Comparative Example 2 in which the gas pipe material was changed to monel metal alloy and the stainless valve was used as it was, the increased quantity of the optical loss was lower than that in Comparative Example 1.

Further, in Comparative Example 1, the chromium concentration detected from the $MgF_2$ film surface after the fluorination with heat was 30,000 ppm. In comparative Example 2, the chromium concentration was 3,000 ppm. It was found by the TOF-SIMS analysis in the film depth direction that in any of the $MgF_2$ films in Comparative Examples 1 and 2, chromium was deposited on only the surface and was almost absent inside the film. Briefly, it may be concluded that during the fluorination with heat, chromium was generated and deposited on the film surface thereby increasing the optical loss. Further, the titanium concentration detected from the $MgF_2$ film surface after the fluorination with heat with the same method as in the detection of the chromium concentration was 80 ppm in Comparative Example 1 and the titanium concentration in Comparative Example 2 was 75 ppm.

The reason that Comparative Example 1 and Comparative Example 2 had the above-described results is considered as follows.

In the first place, it was found out by X-ray photoelectron spectroscopy (XPS) that the bonding conditions of chromium detected from the $MgF_2$ film surface in Comparative Examples 1 and 2. The chromium on the film surface was present was as chromium oxide $Cr_2O_3$. It was also found that the film loss increased after the fluorination with heat because chromium oxide $Cr_2O_3$ that absorbed vacuum ultraviolet light and did not transmit was deposited on the film surface. This chromium oxide $Cr_2O_3$ was chemically bonded with the fluoride film surface firmly so that only the chromium oxide could not be removed with washing from the fluoride film as it remained. Accordingly, there was no alternative but to remove the chromium oxide and the fluoride film simultaneously with polishing.

Further, the present inventors revealed the reason that nevertheless the heat treatment was carried out in a fluorine atmosphere, chromium oxide $Cr_2O_3$ was deposited on the film surface.

$F_2$ gas is contacted with stainless steel and thereby $F_2$ gas causes chemical reaction, as shown below, together with chromium, which is one element constituting stainless steel to generate chromium fluoride $CrF_5$.

$$2Cr + 5F_2 \rightarrow 2CrF_5 \uparrow \quad (1)$$

This chromium fluoride $CrF_5$ is a gas so that it was transported to a reactor 5 in a gas stream to adsorb to the inner wall of the reactor 5, a jig for fixing optical elements 6 or the fluoride thin film surface of a fluoride optical element 7. Further, when the fluorination reaction (fluorination with heat) is completed and the reactor 5 is released via purging with helium gas, the chromium fluoride $CrF_5$ gas adsorbed causes chemical reaction, as shown below, together with atmospheric oxygen gas or water vapor to be solid chromium oxide $Cr_2O_3$ deposited on the film.

$$2CrF_5 + 3H_2O \rightarrow Cr_2O_3\downarrow + 6HF \uparrow + 2F_2 \uparrow \quad (2)$$

$$4CrF_5 + 3O_2 \rightarrow 2Cr_2O_3 \downarrow + 10F_2 \uparrow \quad (3)$$

On the basis of the no good results of the comparative examples, we found that it is important to remove chromium from the gas-contacting surface and its neighborhood over the whole fluorine gas feeding system and reaction system including from a fluorine gas generating source to the reactor via the gas pipe as much as possible.

Example 2

Utilizing the completely chromium-free experimental facility prepared in Example 1, a $F_2$ lithography antireflection film was fluorinated. With regard to an optical element prepared by forming the antireflection films comprising $MgF_2$ and $LaF_3$ alternate layers on the both surfaces of a parallel and plat fluorite substrate having a thickness of 3 mm, the results of measuring a spectral transmittance are shown in Fig. 5. It was easily found that the transmittance in the vacuum ultraviolet region of a wavelength of less than 185 nm was really improved by conducting the fluorination with heat according to the present invention. With shortening the wavelength, a marked difference between the conducting of the fluorination with heat or not was recognized. The difference of the transmittance in the wavelength of 157 nm was 4 %. Only one optical element had a 4 % transmittance difference. Therefore, when all of the optical elements of a semiconductor exposure apparatus comprising several ten sheets of optical element are subjected to fluorination with heat according to the present invention, light strength that circuit patterns reaches to a wafer where the circuit patterns are transferred and exposed increases several ten % and exposure properties and throughput can be improved remarkably.

Furthermore, five sheets of the optical element same as those in Fig. 5 were placed, and measurement of the transmittance thereof was continued with $F_2$ laser irradiation. The results are shown in Fig. 6. With regard to the optical elements no subjected to fluorination (fluorination with heat), the transmittance decreased together with the number of laser shot. With regard to the optical elements subjected to fluorination, a lowering of the transmission due to laser irradiation could not be observed at all. Specifically, this data discloses that conducting the fluorination of the present invention could vastly reinforce the resistance to vacuum ultraviolet laser light. The O and OH concentrations, which are factors of light absorption in the vacuum ultraviolet region, were vastly decreased so that the laser resistance could be remarkably improved. Therefore, using the fluorination technique of the present invention, it is possible to not only improve the exposure properties and throughput remarkably, but also prolong an optical element life and further to decrease the number of times of maintenance for element change significantly.

Example 3

Single crystal fluorite of calcium fluoride ($CaF_2$) was processed to be in a parallel flat shape. The surface precise polishing (final polishing) of the single crystal fluorite was carried out by buff polishing with suede cloth dusted with a suspension prepared by dispersing silicon dioxide ($SiO_2$) polishing abrasive grain in water to prepare a fluorite optical element having a polished surface. The resulting fluorite optical element was sucesssively washed with a neutral detergent, distilled water and isopropyl alcohol in a conventional method and thereby polishing abrasive grain and organic matters remained on the surface of the fluorite optical element were removed.

Subsequently, using a fluorination apparatus (washing apparatus) as shown in Fig. 1, the fluorite optical element was fixed to a fluoride optical element-fixing jig 6 made of pure nickel provided inside a reactor (cleaning vessel) 5 made of pure nickel and thereafter the cleaning vessel 5 was sealed to store the fluorite optical element.

Next, the inside of the cleaning vessel 5 was evacuated with a exhaust system 12 until $10^{-5}$ Pa, and then while passing helium gas through a monel metal fluorine gas pipe 3 into the cleaning vessel 5, the temperature of a gas atmosphere in the cleaning vessel 5 was elevated with an external heater 9 capable of PID control to 150°C, was kept for 12 hr and was deaerated to remove moisture inside the cleaning vessel 5.

Next, fluorine gas fed from a fluorine gas generator 1 was diluted with helium gas to have a concentration of 1% and introduced into the cleaning vessel 5 through a gas pipe 3 and a valve 4 which gas-contacting portion was treated with nickel coating. In the fluorine gas generator 1, a nickel vessel filled with a fluoronickel compound was used. Using the external heater 9, the fluorine gas generator 1 was heated at 350°C, and dissociation was caused by thermal decomposition of the fluoronickel compound to generate fluorine gas. The temperature of the gas atmosphere inside of the cleaning vessel 5 was set to 100°C. Using a flow rate/pressure control device 11 disposed in the lower side of the cleaning vessel 5, the indicated value of a pressure gauge 10 was regulated to be 0.1 MPa (atmospheric pressure) and timing was started. An exhaust system 12 was released and gas passing was continued for 1 hr and thereby fluorination reaction on the polished surface of the fluorite optical element surface was advanced. After the passage of 1 hr, the temperature of the cleaning vessel 5 was cooled to room temperature, and thereby the fluorination reaction was finished.

Next, fluorine gas introduction was stopped and the inside of the cleaning vessel 5 was evacuated followed by sufficient purging with helium gas. Thereafter, the purging with helium gas was stopped and the cleaning vessel was released, and the fluorite optical element 1 treated with fluorination (cleaning treatment) completely was taken out.

The polished surface of the resulting fluorite optical element 1 was measured by TOF-SIMS (time of flight secondary ion mass spectrometer) and the results are shown in Table 7. From Fig. 7, it was confirmed that the fluorite optical element 1 prepared in Example 3 had higher detected amounts of both elements of Ca atom and F element as compared with the surface of a fluorite optical element 2 prepared in Comparative Example 3 as described later, and had a F/Ca ratio of 2 which was an almost stoichiometric composition. Further, Si atom was not detected at all, and O atom was detected slightly. It is considered that the O atom slightly detected originated from physical absorbed water.

This result showed that in Example 3, $SiO_2$ used as polishing abrasive gain was stuck on the surface of the fluorite optical element and/or chemical reaction between $SiO_2$ and $CaF_2$ on the fluorite optical element surface produced a processing changed layer ($Ca_xSi_yO_mF_n$), and the gain and/or the processing changed layer were reacted with fluorine gas as shown in the formula <1> or the following formula <7> and they were chemically removed with etching and thereby cleaning was conducted.

$$Ca_xSi_yO_mF_n + (x+2Y-n/2)F2 \rightarrow xCaF_2 + {}_ySiF_4 \uparrow + m/2O_2 \uparrow \qquad \text{<7>}$$

The transmittance spectrum T (%) and the reflectance spectrum R (%) of the resultant fluorite optical element 1 were measured with a vacuum ultraviolet spectroscope and a light absorbing loss (100-T-R (%)) was determined. The transmittance spectrum T(%) is shown in Fig. 8 and the light absorbing loss (100-T-R (%)) is shown in Fig. 9.

Figs. 8 and 9 showed that the fluorite optical element 1 prepared in Example 3 had a lower absorbing loss and a higher transmittance in the wavelength region of less than 160 nm as compared with a fluorite optical element 2 subjected to conventional polishing and cleaning prepared in Comparative Example 3, as described later. Further, it was found that the difference between the element of Example 3 and the element of Comparative example 3 became more clearly with shortening the wavelength.

As is clear from the above, it was confirmed that by the production process of the fluorinated product (production process of fluoride optical element) according to the present invention, it was possible to remove easily the processing changed layer derived from silicon dioxide ($SiO_2$) polishing abrasive gain which was not removed by conventional polishing and cleaning methods, and almost complete fluoride optical element surface having a smooth surface and low absorbing loss on the polished surface could be formed.

Still, the fluorite optical element 1 prepared in Example 3 was confirmed to have absorbing loss of about 1% in a short wavelength region, and it was considered that this was caused due to absorption of the fluorite inside.

As is also clear from the above, the polishing and cleaning of the production process of the fluorinated products according to the present invention are extremely effective in optical uses in a wavelength of not more than 160 nm, such as $F_2$(157 nm) lithography or the like in the next generation, and further, the effectiveness to polishing and cleaning by conventional methods is increased with shortening the wave length used.

The resultant fluorite optical element 1 and the fluorite optical element 2 prepared in Comparative Example 3 as described below were observed on the unevenness of the surfaces thereof by an inter-atomic microscope. In result, a marked difference of smoothness between them was not found so that the production process of the present invention is applicable for fluoride optical elements with no problems.

<u>Comparative Example 3</u>

Fluorite processed in a parallel flat shape was subjected to buff polishing in the same manner as in Example 3, to prepare a fluorite optical element having a polished surface.

Subsequently, the resulting fluorite optical element was successively washed with a neutral detergent, distilled water and isopropyl alcohol in a conventional method and thereby polishing abrasive grain and organic matters remained in the surface of the fluorite optical element were removed, to prepare a fluorite optical element 2.

The polished surface of the resulting fluorite optical element 2 was measured with TOF-SIMS (time of flight secondary ion mass spectrometer) in the same manner as in Example 3. The results are shown in Fig. 7 together with the results of Example 3. In the fluorite optical element 2, the F/Ca ratio was considerably lower as compared with the stoichiometric composition of 2 and very large amounts of Si atom and O atom were detected in addition to Ca atom and F atom. From this fact, it is considered that the fluorite optical element 2 was in a state that silicon dioxide ($SiO_2$) used as polishing abrasive gain was stuck on the surface of the fluorite optical element and/or chemical reaction between $SiO_2$ and $CaF_2$ on the fluorite optical element surface produced a processing changed layer ($Ca_xSi_yO_mF_n$). From

this result, it is clear that conventional polishing and cleaning methods cannot remove polishing abrasive gain (Si atom or O atom) remained on the fluorite optical element surface after polishing.

The transmittance spectrum T (%) and the reflectance spectrum R (%) of the resultant fluorite optical element 2 were measured with a vacuum ultraviolet spectroscope in the same manner as in Example 3 and light absorbing loss (100-T-R (%)) was determined. The transmittance spectrum T(%) is shown in Fig. 8 and the light absorbing loss (100-T-R (%)) is shown in Fig. 9 together with the results of Example 3.

It was found that when the wavelength is not more than 160 nm, the transmittance lowers because light absorption generates due to the polishing abrasive gain remained on the fluorite optical element surface.

## Example 4

The procedure of Example 3 was repeated except that the fluorine gas generator 1 in the cleaning apparatus as shown in Fig. 1 was changed to an electrolytic cell of hydrogen fluoride as shown in Fig. 10 and fluorination (cleaning treatment) of a fluorite optical element was carried out.

In Fig. 10, the number 25 denotes an electrolytic cell, 26 denotes hydrogen gas, 27 denotes a cathode, 28 denotes a diaphragm, 29 denotes a direct current voltage source, 30 denotes an insulator, 31 is fluorine gas, 32 denotes an anode and 33 denotes a electrolyte. The electrolyte 33 was a molten mixture of hydrogen fluoride and potassium fluoride (KF) (a molar composition ratio HF/KF of 2) and electrolysis was conducted at about 100°C to generate fluorine gas.

The fluorite optical element prepared from the treatment was analyzed by the same method as in Example 3. In result, it was confirmed that the fluorite optical element was equivalent to the fluorite optical element 1 prepared in Example 3. From the result, it was clarified that according to the production process of the fluorinated products of the present invention, even in the case of selecting the hydrogen fluoride electrolytic cell as a fluorine gas generator, the processing changed layer derived from silicon dioxide polishing abrasive gain can be easily removed although it cannot be removed by conventional polishing and cleaning methods, and almost complete fluoride optical element surface which is smooth and has low absorption loss on the polished surface can be formed.

## Example 5

The procedure of Example 3 was repeated except that the fluorine gas generator 1 in the cleaning apparatus as shown in Fig. 1 was changed to a monel metal cylinder filled with fluorine gas and fluorination (cleaning treatment) of a fluorite optical element was carried out.

The fluorite optical element prepared from the treatment was analyzed by the same method as in Example 3. In result, it was confirmed that the fluorite optical element was equivalent to the fluorite optical element 1 prepared in Example 3.

From the result, it was clarified that according to the production process of the fluorinated products of the present invention, even in the case of selecting the cylinder filled with fluorine gas as a fluorine gas generator, the processing changed layer derived from silicon dioxide polishing abrasive gain can be easily removed although it cannot be removed by conventional polishing and cleaning methods, and almost complete fluoride optical element surface which is smooth and has low absorption loss on the polished surface can be formed.

## Example 6

The procedure of Example 3 was repeated except that the fluorine gas generator 1 in the cleaning apparatus as shown in Fig. 1 was changed to a tetrafluoromethane gas ($CF_4$) plasma generator as shown in Fig. 11 and the cleaning treatment conditions with the fluorination were changed, and fluorination (cleaning treatment) of a fluorite optical element was carried out.

In Fig. 11, the number 34 denotes a plasma chamber, 35 denotes tetrafluoromethane gas, 36 denotes an anode, 37 and 38 denote earth wires, 39 denotes a high-frequency electric source, 40 denotes a blocking condenser, 41 denotes an insulator, 42 denotes a cathode, 43 denotes a fluorine-containing gas and 44 denotes plasma. In this system, tetrafluoromethane was plasma decomposed in a high frequency of 13.56 MHz, in an output of 100 W at a gas pressure inside the plasma chamber of 10 Pa, to generate a fluorine (F)-containing gas. The fluorine (F)-containing gas generated from the plasma chamber was introduced into a reactor (cleaning vessel) 5 through a gas pipe 3 and valve 4 which gas-contacting portion was coated with nickel. The temperature of the gas atmosphere in the cleaning vessel 5 was set at 300°C. Using a flow rate/pressure control device 11 disposed in the lower side of the cleaning vessel 5, the indicated value of a pressure gauge 10 was regulated to be 0.1 MPa (atmospheric pressure) and timing was started. An exhaust system 12 was released and gas passing was continued for 1 hr and thereby fluorination on the polished surface of the fluorite optical element was advanced. After the passage of 1 hr, the temperature of the cleaning vessel 5 was cooled to room temperature, and thereby the fluorination was finished.

The fluorite optical element prepared from the treatment was analyzed by the same method as in Example 3. In result, it was confirmed that the fluorite optical element was equivalent to the fluorite optical element 1 prepared in Example 3.

From the result, it was clarified that according to the production process of the fluorinated products of the present invention, even in the case of selecting the tetrafluoromethane plasma generator as a fluorine gas generator, the processing changed layer derived from silicon dioxide polishing abrasive gain can be easily removed although it cannot be removed by conventional polishing and cleaning methods, and almost complete fluoride optical element surface which is smooth and has low absorption loss on the polished surface can be formed.

Comparative Example 4

Fluorite processed in a parallel flat shape was subjected to buff polishing in the same manner as in Example 3, to prepare a fluorite optical element having a polished surface.

Subsequently, the resulting fluorite optical element was treated using other polishing abrasive gain such as cerium oxide or the like to remove a processing changed layer physically. Thereafter, the resulting fluorite optical element was successively washed with a neutral detergent, distilled water and isopropyl alcohol in a conventional method. However, it was confirmed that polishing abrasive grain remained in the surface of the fluorite optical element after the final polishing, and light absorption derived from polishing abrasive gain was generated.

Example 7

A $MgF_2$ single layer film having a film thickness of 150 nm was deposited on a fluorite substrate with a vacuum deposition method to prepare a sample. The sample was subjected to densification in accordance with the production process of the fluorinated product (the process for densification of a fluoride thin film on a fluoride optical element) as described in the embodiment of the invention involving the above-described densification of the fluoride optical thin film.

Hereinafter, the densification is described with reference to Fig. 2. That is, the sample was cleaned and then was fixed to an optical element fixture 6 inside a treating vessel (reactor) 5 (enclosure step). Using a vacuum pump, gas inside the reactor 5 was exhausted through a gas-exhausting vent 14 until the pressure inside the reactor 5 reached to $10^{-4}$ Pa and thereafter, while helium gas was introducing through a gas-inlet 3 into the reactor 5, the sample present in the reactor 5 was heated to 150°C with an external heater 9, and kept for 12 hr to conduct de-airing for removal of moisture (water content exhaust step). A thermo-couple 24 was used for measuring the sample temperature.

Subsequently, fluorine gas diluted with helium gas to 10 ppm was introduced into the reactor 5. While the diluted fluorine gas flow rate was regulated using a flow rate/pressure control device 11 so that the pressure inside the reactor 5 was 0.1 MPa, and the temperature inside the reactor 5 was heated to 300°C to carry out fluorination reaction (densification treatment step). After the temperature reached to 300°C, timing for the densification treatment was started and the temperature and the pressure were kept to be 300°C and 0.1 MPa respectively.

Next, heating inside the reactor 5 was stopped and then cooling inside the reactor 5 was started with keeping the same fluorine gas concentration (cooling step). When the temperature inside the reactor 5 lowered to room temperature, the introduction of diluted fluorine gas was stopped and the inside of the reactor 5 was exhausted and purged with helium gas. The helium gas purging was stopped and the reactor 5 was released and then the objective sample densification treated was taken out (withdrawal step).

With regard to the $MgF_2$ single layer film, which was a sample, the cross sectional SEM photographs thereof before and after the treatment are shown in Fig. 12.

From the observation of the cross section of as-depo film before the treatment, it is found that thin pillars were extended from the interface between the substrate and the film toward to the film surface and the film was formed by the thin pillars in a bound state. The as-depo film is a typical pillar structure. Simultaneously, it is easily confirmed that among the thin pillars, there are gaps through which low molecular weight gas can be readily passed. On the surface of each of the thin pillars, a volatile substance can be adsorbed. The primary specific surface area of the film was quite vast as compared with the area of the surface of the film upper portion. Meanwhile, concerning the film treated with densification according to the present invention, it is confirmed that as a result of heating, thin pillars are adhered each other and thereby each of the pillars is thickened so that the gaps between the pillars are closed or narrowed to change into a minute structure.

Example 8

In a semiconductor exposure system, as described above, the inside of a lenstube holding an optical element was purged with nitrogen gas. It is found from the results of the trace gases analysis that volatile impurities having a possibility that they will enter the lens tube are oxygen, water vapor, aromatic organic substances, siloxane organic substances or ammonia. Among them, the aromatic organic substances and siloxane organic substances adsorb on the optical thin film surface of the optical element and thereafter, optical CVD reaction is caused by laser irradiation and thereby the substances are polymerized and adhered to lower the transmittance of the optical element. Such a phenomenon that these organic substances are polymerized and adhered on the optical thin film is called "cloudiness".

The exposure properties and productivity of the exposure system depend on whether the fluoride optical element with the fluoride optical thin film employed in the semiconductor exposure system is easy of causing cloudiness or difficult of causing cloudiness. The present inventors artificially made the circumstances that cloudiness generates in the fluoride optical element with the fluoride optical thin film. Under the circumstances, the fluoride optical element with the fluoride optical thin film was irradiated with laser and then the transmittance difference thereof was measured. It was confirmed by the experiment that the degree of cloudiness has large difference according to the structure of the thin film. The experiment process and the results are described below.

Fig. 13 is a structural diagram of a laser irradiation experiment apparatus. The apparatus was made for the purpose of irradiating ArF excimer laser on an optical element having a surface laminated with an optical thin film. The apparatus, further, has a structure such that laser irradiation can be conducted by changing the gas circumstances inside the chamber holding the optical element or the impurity concentration. Therefore, the laser irradiation experiment apparatus is an experiment apparatus capable of obtaining the same results as the case that optical elements such as lens, prism or mirror are held in a lens tube of an actual semiconductor exposure apparatus.

As shown in Fig. 13, ArF laser light injected from an ArF laser oscillator 45 is introduced into a chamber 46 holding an optical element 49 through an ArF laser beam path 47. That is, ArF excimer laser light is introduced into the chamber 46 through an open-close shutter 48, a waveguide 50 and an entrance side fluoride window 51 provided between the ArF laser oscillator 45 and the chamber 46.

Inside the chamber 46, an optical element support 52 for supporting the optical element 49 is provided and on the optical element 49, which is supported by the optical element support 52, an optical thin film 54 is formed. In the chamber 46, an exit side fluoride window 56 is provided and ArF excimer laser injected from the exit side fluoride window 56 is entered into a joule meter 62 through a waveguide 58 and an open-closed shutter 60. In the chamber 46, a gas introduction pipe 64 and an open-close valve 66 which conducts opening and closing the gas introduction pipe 64 are provided and also a gas exhaust pipe 68 and an open-close valve 70 which conducts opening and closing the gas exhaust pipe 68 are provided.

First, a sample was prepared by forming a DUV region antireflection film composed of $MgF_2/LaF_3$ alternating laminate on the both sides of a parallel and flat fluorite substrate having a thickness of 3 mm. Two sheets of the sample was prepared, and one was put aside as an as-depo film sample without treatment and the other was subjected to densification treatment for a fluoride according to the present invention and then was taken as a densification treated film sample.

With regard to each of the as-depo film sample and the densification treated sample, the transmittance spectrum just before irradiation with ArF excimer laser was measured by a spectral transmittance measuring apparatus. The transmittance spectrums measured are shown in Figs. 14 and 15 respectively.

Next, the as-depo film sample was held inside the laser irradiation experiment apparatus as shown in Fig.13. While a mixed vapor composed of toluene typified aromatic organic matters and octamethylcyclotetrasiloxane typified siloxane organic matters was circulated by nitrogen gas inside the laser irradiation experiment apparatus, the sample was irradiated with ArF excimer laser at $10^6$ shot.

Then, the densification treated film sample was held inside the laser irradiation experiment apparatus as shown in Fig. 13. While the same mixed vapor composed of toluene and octamethylcyclotetrasiloxane was circulated by nitrogen gas inside the laser irradiation experiment apparatus, the sample was irradiated with ArF excimer laser at $10^6$ shot.

Lastly, with regard to both samples of the as-depo film and the densification treated film, after the irradiation with ArF excimer laser, the transmittance spectrums were measured by the spectral transmittance measuring apparatus. The transmittance spectrums measured are shown in Figs. 14 and 15 respectively. In both of the results of Figs. 14 and 15, the transmittance lowered after the laser irradiation and the spectrum was shifted to the long wavelength side. The results show that polymeric products absorbing ultraviolet light are deposited. That is, the transmittance lowered by absorbing light and the polymeric products are deposited on the optical thin film to increase the film thickness and thereby the spectrum is shifted to the long wavelength side.

When the as-depo film sample in Fig. 14 and the densification treated sample in Fig. 15 are compared, the densification treated sample has a lowering of the transmittance and shift of the spectrum to the long wavelength side, which are remarkably smaller than those of the as-depo film. According to the densification treatment process of the present invention, by densifying the structure of the optical thin film and removing gaps or pores, impurities cannot enter and cannot adsorb into the film inside through gaps or pores so that a lowering of the transmittance due to polymerized film deposition can be remarkably restrained.

When the fluoride optical element having a densification treated fluoride optical thin film, which is a fluorinated product prepared by the production process of the fluorinated product of the present invention (densification treatment method) is employed in a semiconductor exposure system, in the semiconductor exposure system where ultraviolet KrF excimer laser wavelength, deep ultraviolet ArF excimer laser wavelength, and vacuum ultraviolet $F_2$ laser wavelength are used for an exposure light source, a transmittance lowering (cloudiness) of the fluoride optical thin film can be depressed extremely. The transmittance lowering is induced by adsorbing and polymerizing volatile organic matters or volatile inorganic matters remained in the lens tube holding the optical element, with the fluoride optical thin film.
Therefore, a transmittance lowering or occurrence of illuminance nonuniformity can be depressed and thereby the productivity of the semiconductor exposure system can be remarkably improved.

Example 9

The present inventor have been earnestly studied and found that in order to densify the fluoride optical thin film with lowering the optical absorption loss of the fluoride optical thin film, it is necessary to heat the fluoride optical thin film in an atmosphere of fluorine gas. The specific experiment results are shown below.
A sample was prepared by forming an antireflection film used for 157 nm light, which film was composed of $MgF_2/LaF_3$ alternating laminate, on the both sides of a parallel and flat fluorite substrate having a thickness of 3 mm. The sample was subjected to densification treatment in an atmosphere of fluorine gas in accordance with the production process of the fluorinated products (process for densification treating the fluoride thin film on the fluoride optical element) as described in the embodiment of the invention according to densification of the fluoride optical thin film. The densification treatment is described below with reference to Fig. 2. That is, the sample was cleaned and then fixed on an optical element fixture 6 inside a treating vessel (reactor) 5 (enclosure step). Using a vacuum pump, the gas inside the reactor 5 was exhausted until the pressure inside the reactor 5 reached to $10^{-4}$ Pa and thereafter, while helium gas was introducing through a gas-inlet 3 into the reactor 5, the sample present in the reactor 5 was heated to 150°C with an external heater 9, and kept for 12 hr to conduct de-airing for removal of moisture (water content exhaust step). A thermo-couple 24 was used for measuring the sample temperature.
Subsequently, fluorine gas diluted with helium gas to 10 ppm was introduced into the reactor 5. While the diluted fluorine gas flow rate was regulated using a flow rate/pressure control device 11 so that the pressure inside the reactor 5 was 0.1 MPa, the temperature inside the reactor 5 was heated to 300°C to carry out fluorination (densification treatment step). After the temperature reached to 300°C, timing for the densification treatment was started and the temperature and the pressure were kept to be 300°C and 0.1 MPa respectively.
Next, heating inside the reactor 5 was stopped and then cooling inside the reactor 5 was started with keeping the same fluorine gas concentration (cooling step). When the temperature of the reactor 5 lowered to room temperature, the introduction of diluted fluorine gas was stopped and the inside of the reactor 5 was exhausted and purged with helium gas. The helium gas purging was stopped and the reactor 5 was released and then the objective sample densification treated was taken out (withdrawal step). This sample was called a film densification treated in a fluorine atmosphere.
With regard to the film densification treated in an atmosphere of fluorine, the transmittance spectrum measured by a spectral transmittance measuring apparatus is shown with a solid line in a graph of Fig. 16. The film densification treated in a fluorine atmosphere has a higher transmittance with shortening the wavelength as compared with the as-depo film as described later. This reason was that when the densification reaction is progressed with heating the fluoride thin film in an atmosphere of fluorine, fluorination of the fluoride thin film is simultaneously caused, and thereby a slight portion free from fluorine present in the fluoride thin film is refilled with fluorine and optical absorbing loss in the vacuum ultraviolet region is decreased.

Comparative Example 5

Two sheets of the sample same as used in Example 9 were prepared. That is, each of two sheets of samples was prepared by forming an antireflection film used for 157 nm light, which film was composed of $MgF_2/LaF_3$ alternating laminate, on the both sides of a parallel and flat fluorite substrate having a thickness of 3 mm. One sample was subjected to densification treatment in an atmosphere of helium free from fluorine. That is, this sample was cleaned and then was fixed to an optical element fixture 6 inside a treating vessel (reactor) 5 as shown in Fig. 2 (enclosure step). Using a vacuum pump, gas inside the reactor 5 was exhausted through a gas-exhausting vent 14 until the pressure inside the reactor 5 reached to $10^{-4}$ Pa and thereafter, while helium gas was introducing through a gas-inlet 3 into the reactor 5, the sample present in the reactor 5 was heated to 150°C with an external heater 9, and kept for 12 hr to conduct de-airing for removal of moisture (water content exhaust step). A thermo-couple 24 was used for measuring the sample temperature.
Subsequently, while the helium gas flow rate was regulated using a flow rate/pressure control device 11 in an atmosphere of helium gas completely free from fluorine so that the pressure inside the reactor 5 was 0.1 MPa, the temperature inside the reactor 5 was heated to 300°C (densification treatment step). After the temperature reached to 300°C, timing for the densification treatment was started and the temperature and the pressure were kept to be 300°C and 0.1 MPa respectively.

Next, heating inside the reactor 5 was stopped and then cooling inside the reactor 5 was started (cooling step). When the temperature of the reactor 5 lowered to room temperature, the reactor 5 was released and then the objective sample densification treated was taken out (withdrawal step). This sample is called a film densification treated in an atmosphere of helium.

The other sample was subjected to no treatment after the film forming. The sample is called an as-depo film.

With regard to the film densification treated in an atmosphere of helium and the as-depo film, the transmittance spectrum measured by a spectral transmittance measuring apparatus is shown with a broken line in a graph of Fig. 16. The film densification treated in an atmosphere of helium has a remarkably lower transmittance, and the transmittance more lowers with shortening the wavelength as compared with the as-depo film. The chemical compositions of both of the samples were specifically analyzed using an electron beam probe microanalysis apparatus (EPMA). In results, the fluorine content of the film densification treated in an atmosphere of helium largely lowered as compared with the as-depo film. Namely, when the densification treatment of the fluoride thin film was progressed with heat in an atmosphere of helium gas or the like except for fluorine as in this case, the fluoride thin film was densified but simultaneously, fluorine atom was detached and evaporated from the fluoride thin film. As a result, the fluoride thin film lacked of fluorine greatly and the optical absorbing loss in the vacuum ultraviolet region increased with shortening the wavelength.

According to Example 9 and Comparative Example 5, heating the fluoride optical element with the fluoride optical thin film in an atmosphere of fluorine gas, the fluoride optical thin film can be densified without increasing the optical absorbing loss of the fluoride optical thin film.

## Claims

**1.** A fluorination treatment apparatus comprising a fluorine gas storage/feed vessel for storing and feeding a fluorine gas, a reactor for bringing a substance to be treated into contact with a fluorine gas to carry out fluorination reaction, and a fluorine gas pipe arranged between the fluorine gas storage/feed vessel and the reactor, wherein at least a portion to be brought into contact with the fluorine gas is constituted of a material having a chromium concentration of not more than 1% and/or a titanium concentration of not more than 1%.

**2.** The fluorination treatment apparatus as claimed in claim 1, wherein the material of at least a portion to be brought into contact with the fluorine gas is at least one of nickel, a nickel alloy, copper, a copper alloy, aluminum and an aluminum alloy.

**3.** A process for producing a fluorination treated substance, comprising:

an enclosure step of enclosing a substance to be treated in a reactor, and
a fluorination reaction step of introducing a fluorine type gas into the reactor to bring the substance to be treated into contact with the fluorine type gas and thereby carry out fluorination reaction.

**4.** A process for producing a fluorination treated substance, comprising:

an enclosure step of enclosing a substance to be treated in a reactor,
a fluorination reaction step of carrying out fluorination reaction of the substance to be treated which has been enclosed in the reactor, and
a heat treatment step of heating the substance to be treated which has been enclosed in the reactor, to the prescribed temperature.

**5.** A process for producing a fluorination treated substance, comprising:

an enclosure step of enclosing a substance to be treated in a reactor,
a water content exhaust step of exhausting water content from the reactor,
a fluorination reaction step of carrying out fluorination reaction of the substance to be treated which has been enclosed in the reactor,
a cooling step of cooling the substance to be treated which has been enclosed in the reactor, and

a withdrawal step of withdrawing the treated substance from the reactor,
wherein the treating temperature in the water content exhaust step is in the range of 100 to 170°C, and
the temperature in the reactor in the fluorination reaction step is in the range of 10 to 150°C, and the fluorine concentration in the reactor in this step is in the range of 1000 ppm to 100%.

**6.** A process for producing a fluorination treated substance, comprising:

an enclosure step of enclosing a substance to be treated in a reactor,
a water content exhaust step of exhausting water content from the reactor,
a fluorination reaction step of carrying out fluorination reaction of the substance to be treated which has been enclosed in the reactor,
a heat treatment step of heating the substance to be treated which has been enclosed in the reactor, to the prescribed temperature,
a cooling step of cooling the substance to be treated which has been enclosed in the reactor, and
a withdrawal step of withdrawing the treated substance from the reactor,
wherein the temperature in the reactor in the fluorination reaction step is in the range of 10 to 150°C, and the fluorine concentration in the reactor in this step is in the range of 1000 ppm to 100%, and
the temperature in the reactor in the heat treatment step is higher than the temperature in the reactor in the fluorination reaction step, and the fluorine concentration in the reactor in the heat treatment step is lower than the fluorine concentration in the reactor in the fluorination reaction step.

**7.** The process for producing a fluorination treated substance as claimed in any one of claims 3 to 6, wherein the fluorination reaction step has:

a pressure control step of controlling the total pressure and the fluorine partial pressure in the reactor to the prescribed pressures, and
a temperature control step of controlling the temperature in the reactor to the prescribed temperature.

**8.** The process for producing a fluorination treated substance as claimed in any one of claims 3 to 7, wherein the total pressure in the reactor in the fluorination reaction step is in the range of 0.01 to 1.0 MPa.

**9.** The process for producing a fluorination treated substance as claimed in any one of claims 3 to 8, wherein the fluorination treatment apparatus of claim 1 or 2 is employed.

**10.** The process for producing a fluorination treated substance as claimed in any one of claims 3 to 9, wherein the substance to be treated is any one of a fluoride thin film, a fluoride powder, a fluoride solid and a fluoride optical element.

**11.** The process for producing a fluorination treated substance as claimed in claim 10, wherein the substance to be treated is a fluoride optical element obtained by abrading a surface of a fluoride solid with abrasive grain.

**12.** The process for producing a fluorination treated substance as claimed in claim 11, wherein the fluorination reaction step is a step of cleaning the fluoride optical element that is the substance to be treated.

**13.** The process for producing a fluorination treated substance as claimed in claim 11 or 12, wherein the abrasive grain is at least one material selected from the group consisting of silicon dioxide, silicon carbide, boron carbide, cubic boron nitride and diamond.

**14.** The process for producing a fluorination treated substance as claimed in claim 13, wherein the abrasive grain is silicon dioxide.

**15.** The process for producing a fluorination treated substance as claimed in any one of claims 11 to 14, wherein the temperature in the reactor in the fluorination reaction step is in the range of 10 to 500°C.

**16.** The process for producing a fluorination treated substance as claimed in claim 10, wherein the fluoride optical element is a fluoride optical element having a fluoride optical thin film laminated thereon.

**17.** The process for producing a fluorination treated substance as claimed in claim 16, wherein the fluorination reaction step is a step of heating the fluoride optical thin film to densify the film.

**18.** The process for producing a fluorination treated substance as claimed in claim 16 or 17, wherein the temperature in the reactor in the fluorination reaction step is in the range of 200 to 400°C, and the fluorine gas concentration in the reactor in this step is in the range of 10 ppm to 100%.

**19.** The process for producing a fluorination treated substance as claimed in any one of claims 10 to 18, wherein the fluoride thin film, the fluoride powder, the fluoride solid and the fluoride optical element are each constituted of at least one material selected from the group consisting of magnesium fluoride, calcium fluoride, lithium fluoride, lanthanum fluoride, aluminum fluoride, neodymium fluoride, gadolinium fluoride, yttrium fluoride, dysprosium fluoride, barium fluoride, sodium fluoride, bismuth fluoride, strontium fluoride, lead fluoride, selenium fluoride, cryolite and chiolite.

**20.** The process for producing a fluorination treated substance as claimed in any one of claims 3 to 19, wherein the fluorine type gas is at least one gas selected from the group consisting of a pure fluorine gas; a fluorine gas diluted with at least one rare gas of helium, neon, argon, krypton and xenon; a gas containing fluorine atoms released during the treatment from the inner surface of the reactor having been previously fluorinated; a gas containing fluorine atoms released during the treatment from a previously fluorinated metal, a fluorine-excess alloy or a fluorine-excess fluoride placed in the reactor; a fluorine gas generated by electrolysis of a metallic fluoride; a gas obtained by sublimating or evaporating a fluorine-rare gas compound of $XeF_2$, $XeF_4$ or $XeF_6$ and a fluorine gas generated by decomposition of the fluorine-rare gas compounds; and a gas containing active fluorine of fluorine radical or fluorine ion generated by dissociating at least one of a carbon-fluorine compound, a sulfur-fluorine compound and a nitrogen-fluorine compound.

**21.** The process for producing a fluorination treated substance as claimed in any one of claims 3 to 20, wherein the fluorine type gas contains a fluorine gas.

**22.** The process for producing a fluorination treated substance as claimed in any one of claims 3 to 21, wherein the fluorine type gas is a gas containing fluorine generated by dissociating a fluorine-containing compound containing at least one material selected from the group consisting of carbon fluoride, sulfur fluoride, nitrogen fluoride, metallic fluoride, hydrogen fluoride, halogen fluoride and fluoride of a rare gas, by means of heat, electricity or plasma, or a fluorine gas.

**23.** A fluorination treated substance obtained by the process of any one of claims 3 to 22.

**24.** The fluorination treated substance as claimed in claim 23, which is a fluoride optical element.

**25.** A fluorination treated substance being a fluoride optical element obtained by the process of any one of claims 12 to 15, wherein the difference in the light absorption loss of the surface at 157 nm between before and after the fluorination treatment is not less than 0.1%.

**26.** A fluorination treated substance obtained by the process of any one of claims 16 to 18, which is a fluoride optical element having a fluoride optical thin film whose pores capable of being invaded by water vapor, a volatile organic matter and a volatile inorganic matter are closed.

Fig. 1

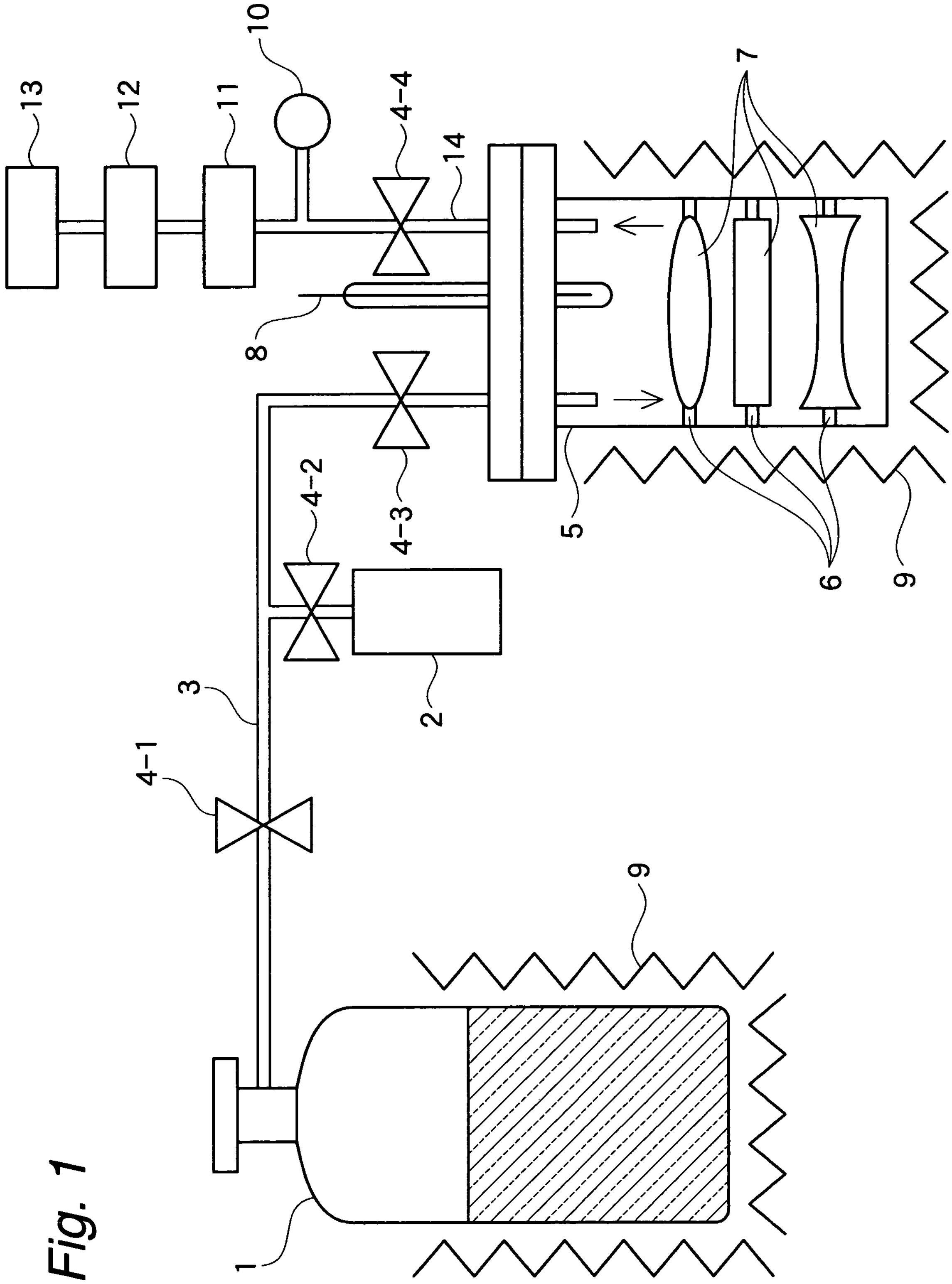

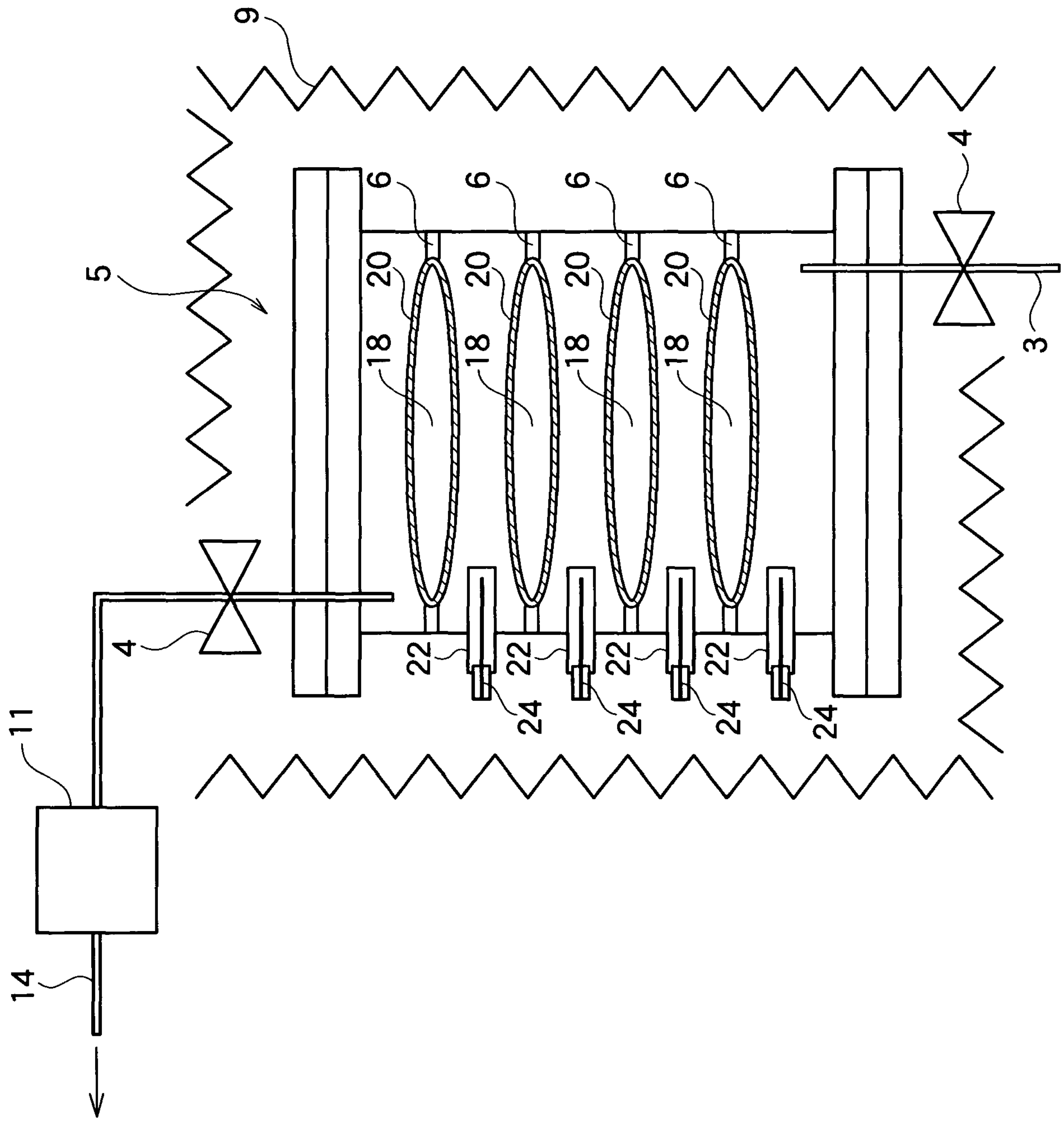


*Fig. 2*

Fig. 3

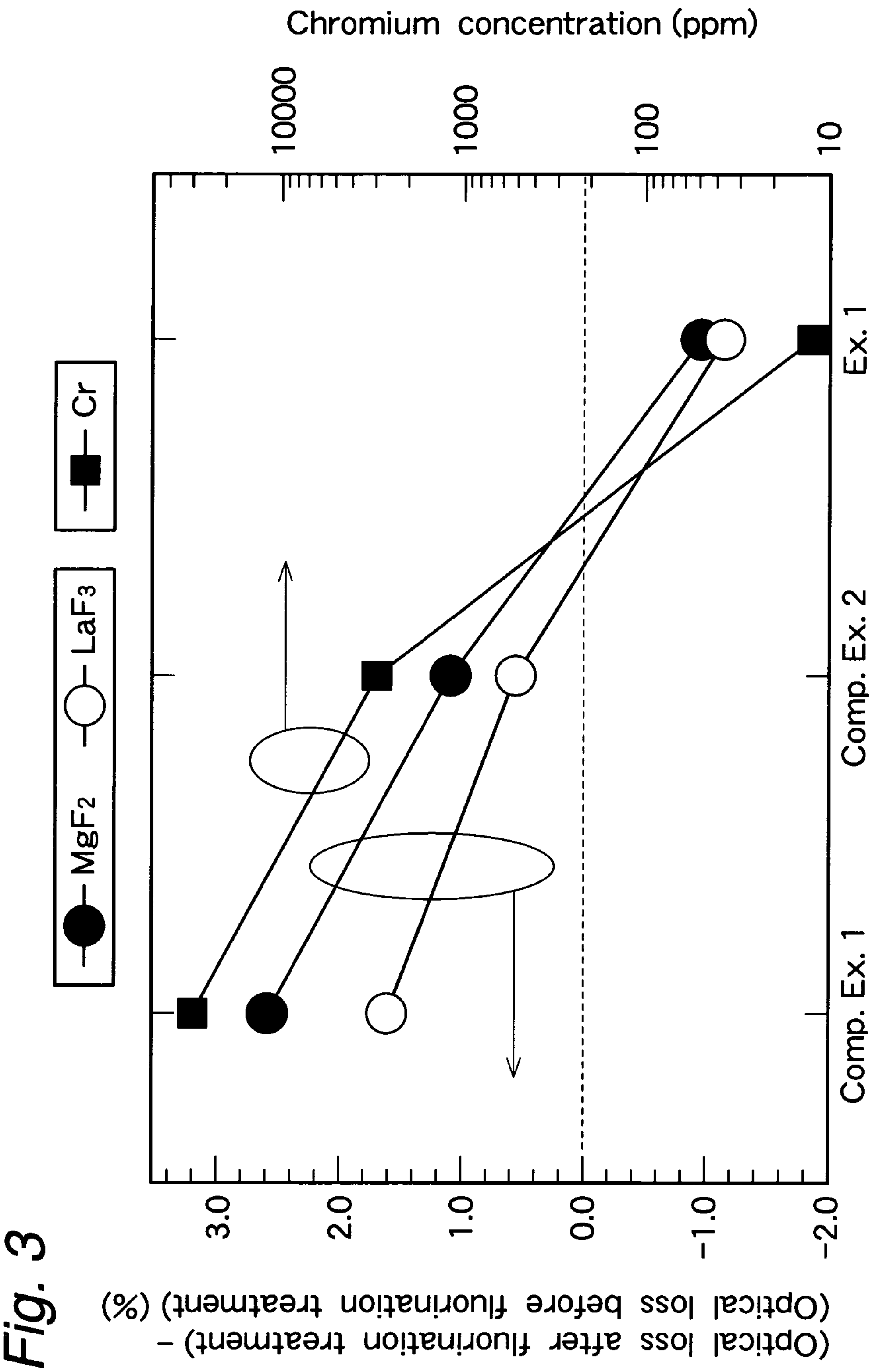

Chromium concentration (ppm)
10000
1000
100
10
MgF2
LaF3
Cr
Comp. Ex. 1
Comp. Ex. 2
Ex. 1
3.0
2.0
1.0
0.0
−1.0
−2.0
(Optical loss after fluorination treatment) − (Optical loss before fluorination treatment) (%)

Fig. 4

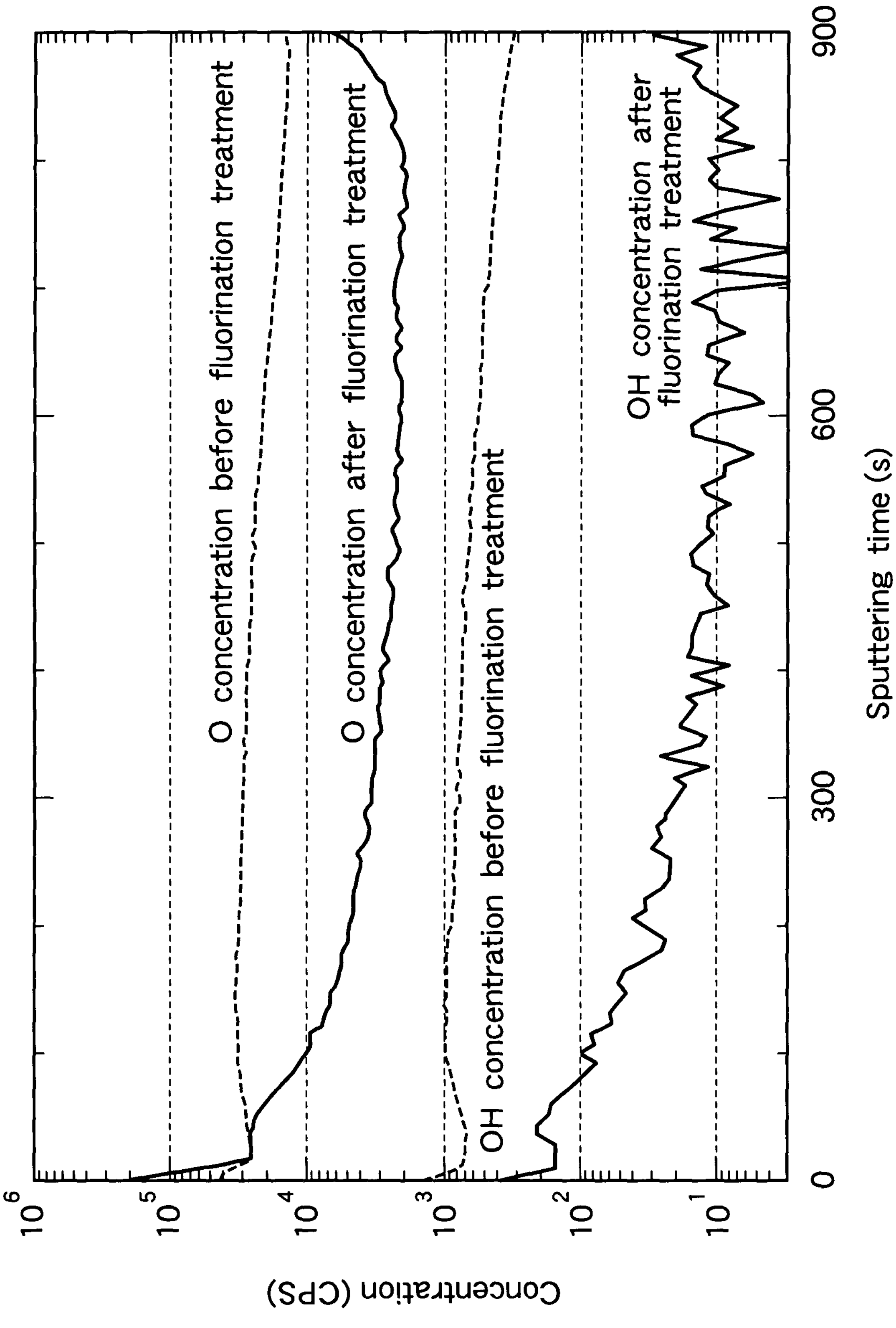
Concentration (CPS)
10^6
10^5
10^4
10^3
10^2
10^1
0
300
600
900
Sputtering time (s)
O concentration before fluorination treatment
O concentration after fluorination treatment
OH concentration before fluorination treatment
OH concentration after fluorination treatment

*Fig. 5*

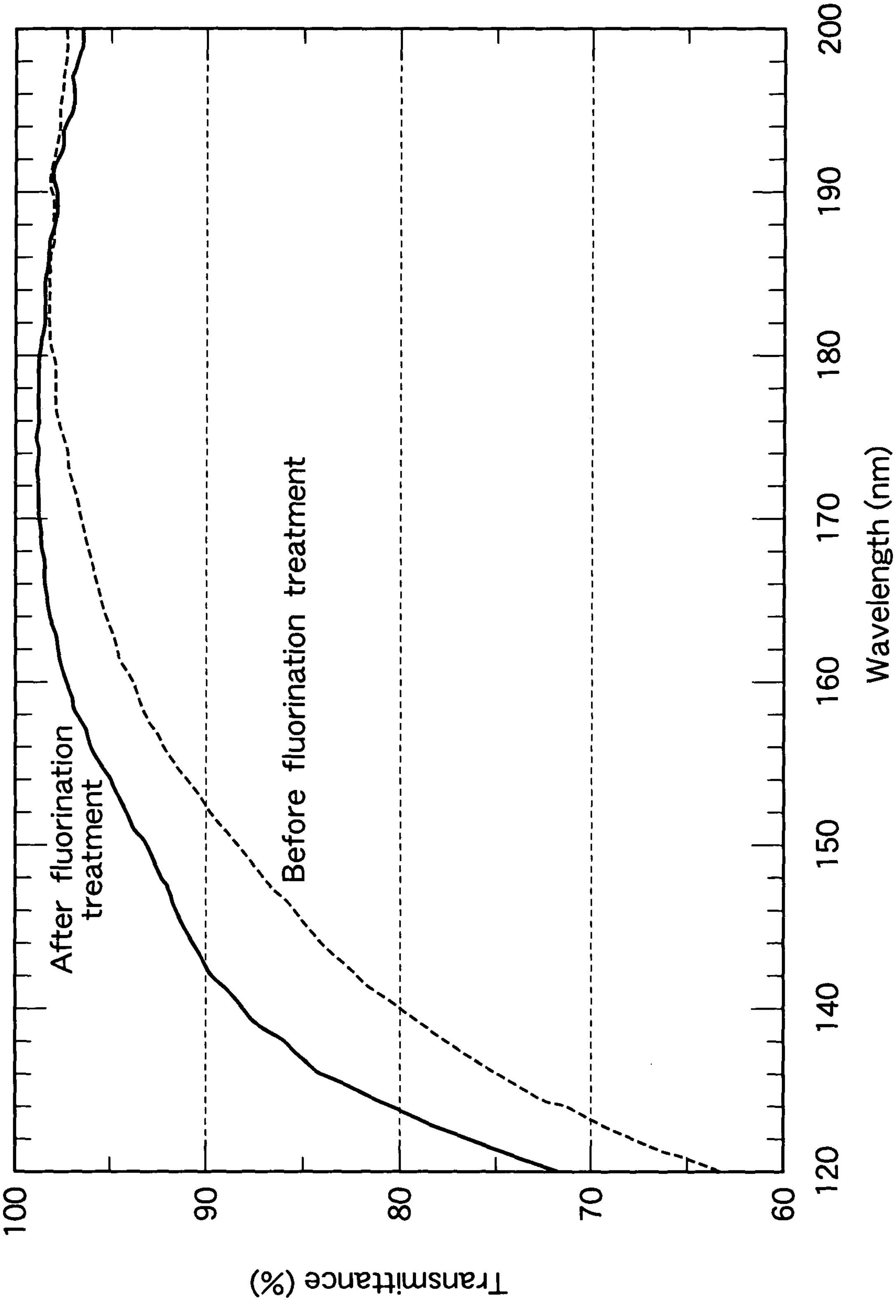
Transmittance (%)
100
90
80
70
60
120
140
150
160
170
180
190
200
Wavelength (nm)
After fluorination treatment
Before fluorination treatment

Fig. 6

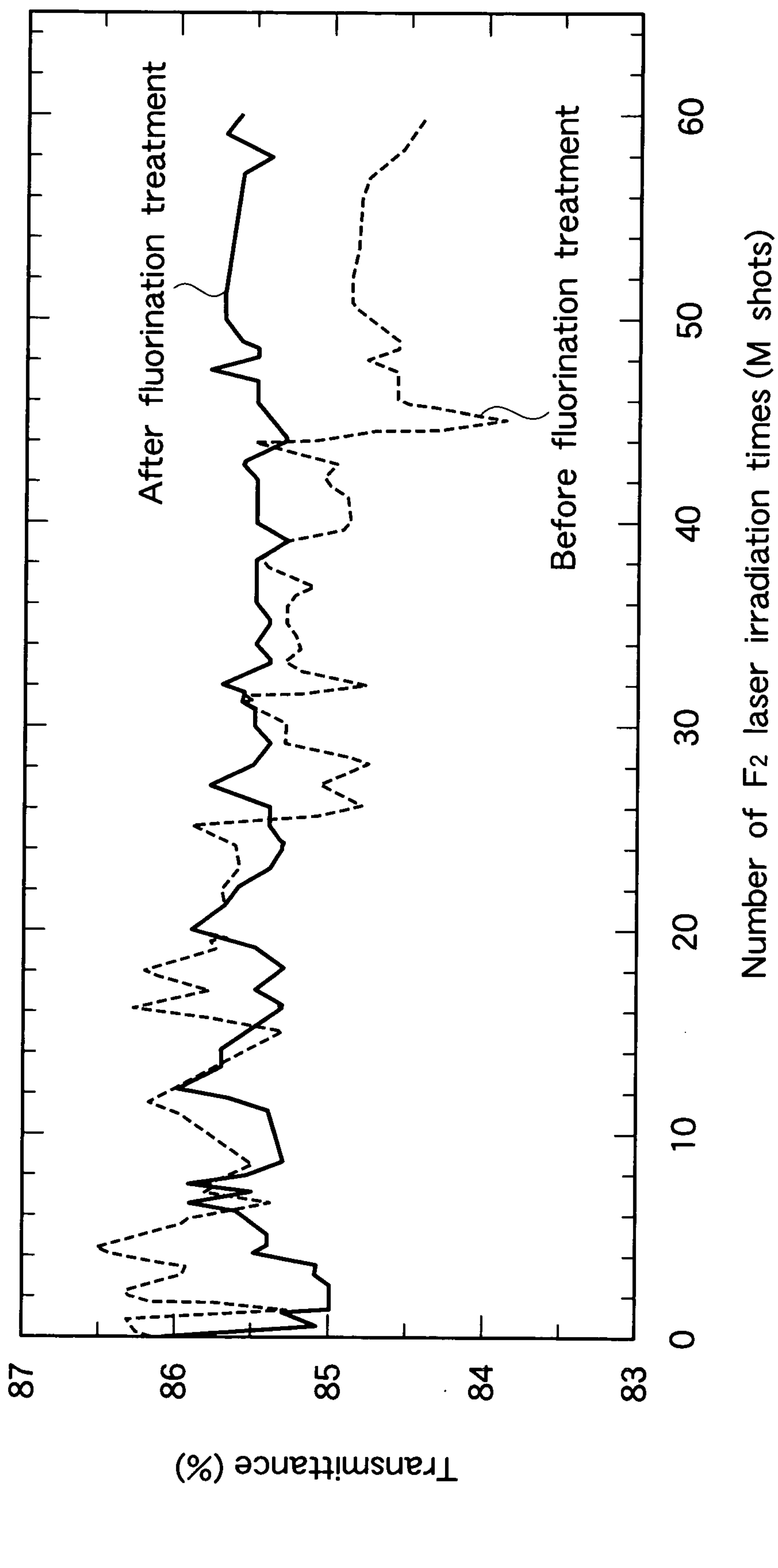
Transmittance (%)
87
86
85
84
83
0
10
20
30
40
50
60
Number of $F_2$ laser irradiation times (M shots)
After fluorination treatment
Before fluorination treatment

*Fig. 7*

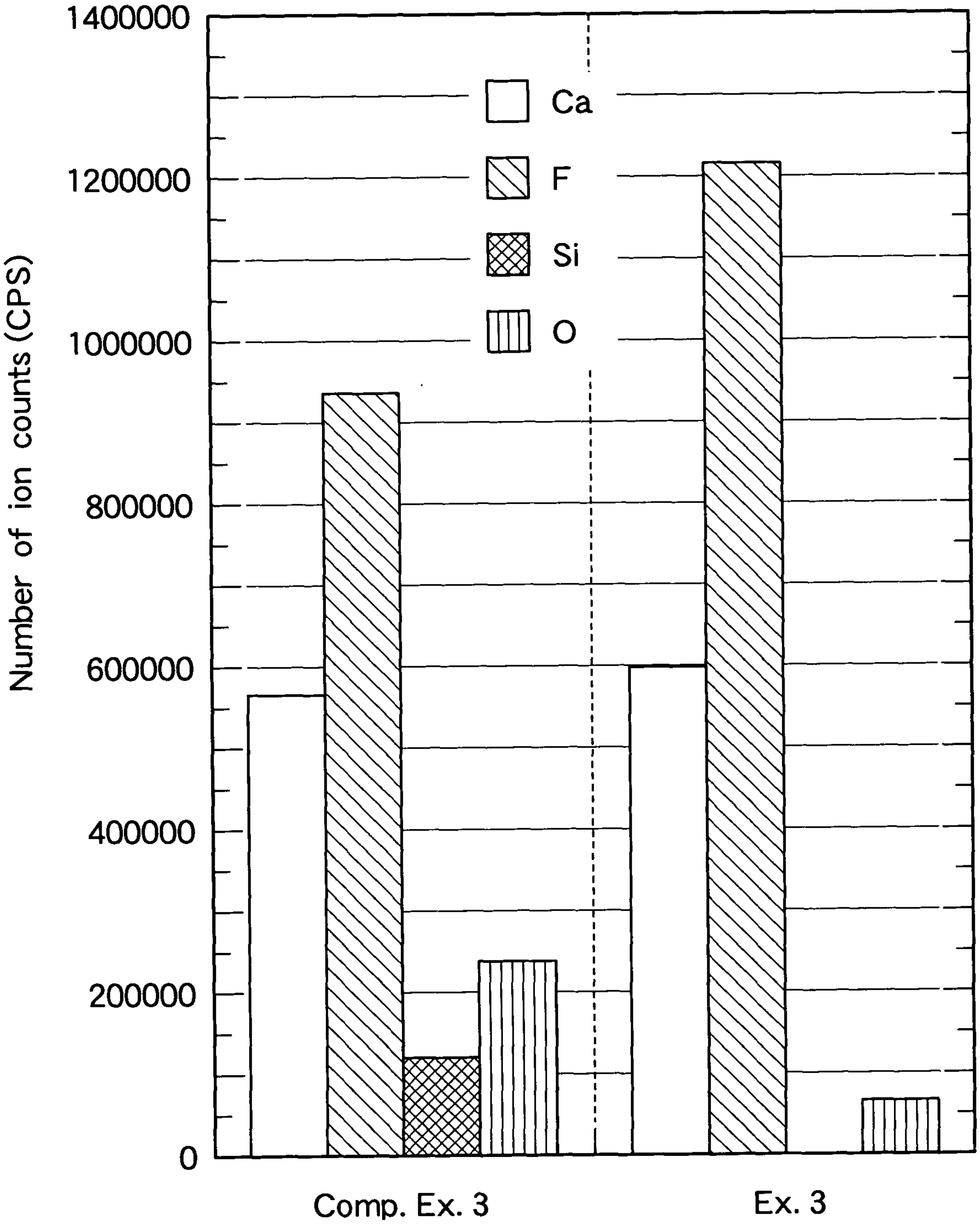
1400000
1200000
1000000
800000
600000
400000
200000
0
Number of ion counts (CPS)
Ca
F
Si
O
Comp. Ex. 3
Ex. 3

*Fig. 8*

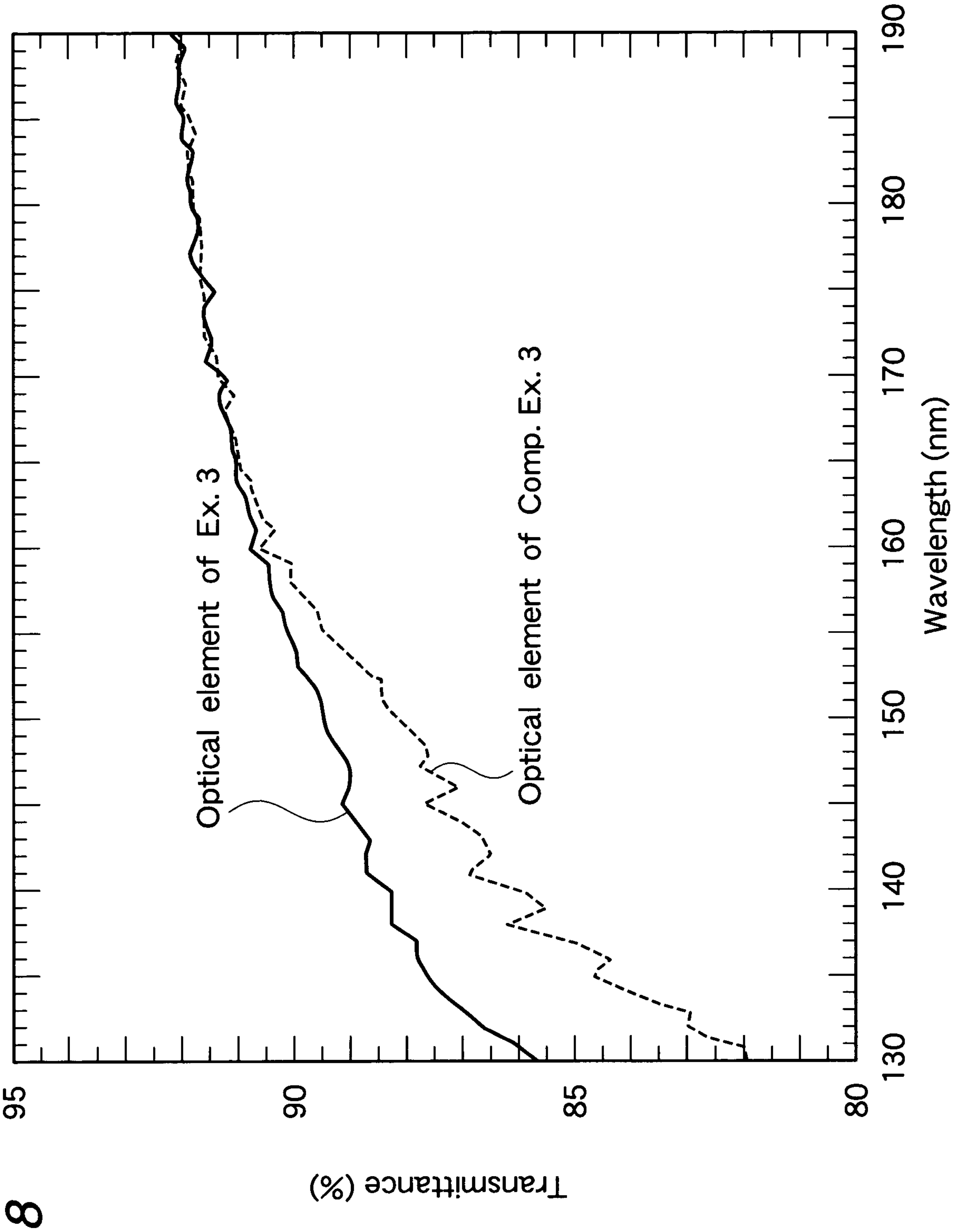
Transmittance (%)
95
90
85
80
130
140
150
160
170
180
190
Wavelength (nm)
Optical element of Ex. 3
Optical element of Comp. Ex. 3

*Fig. 9*

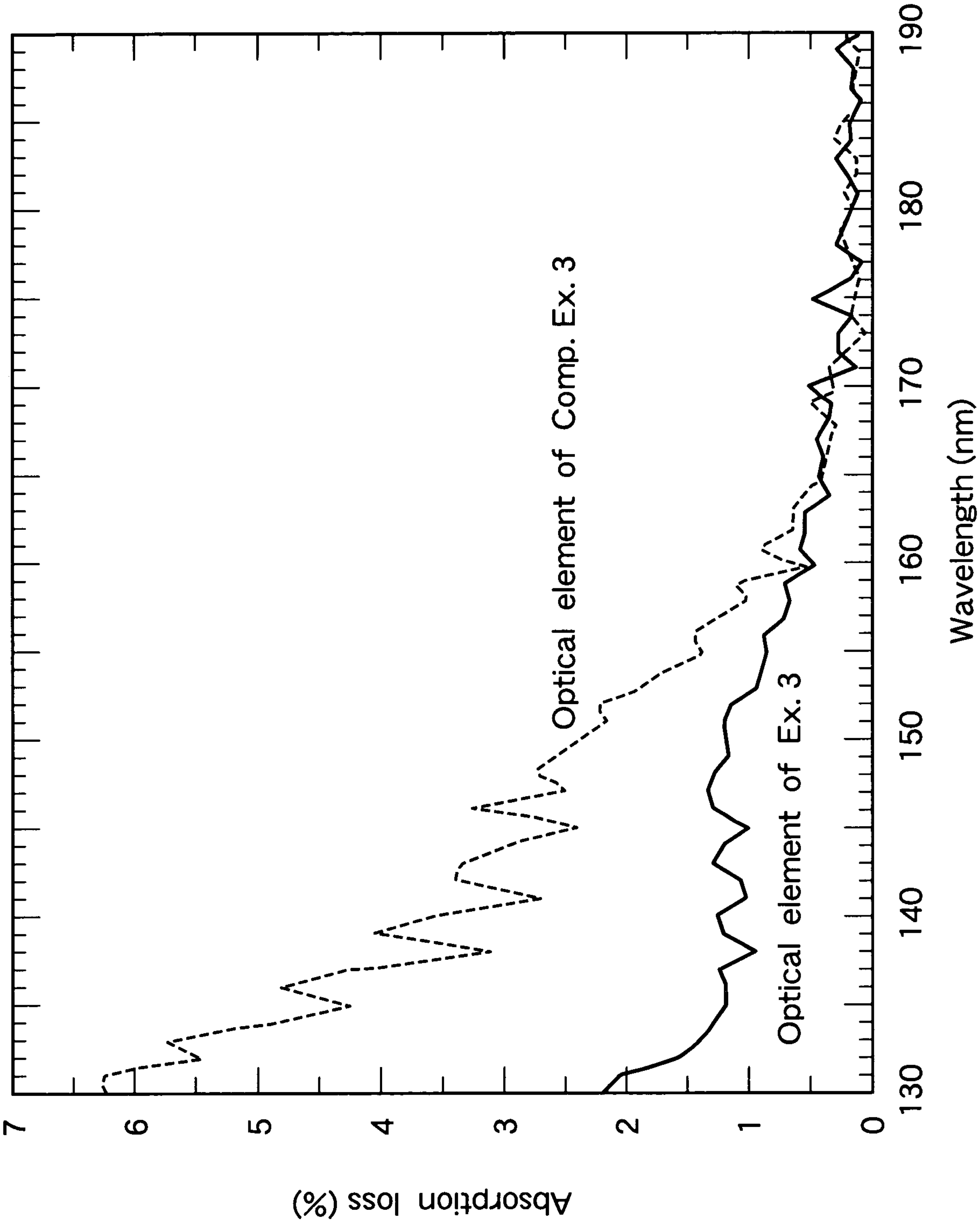
Absorption loss (%)
0
1
2
3
4
5
6
7
130
140
150
160
170
180
190
Wavelength (nm)
Optical element of Comp. Ex. 3
Optical element of Ex. 3

*Fig. 10*

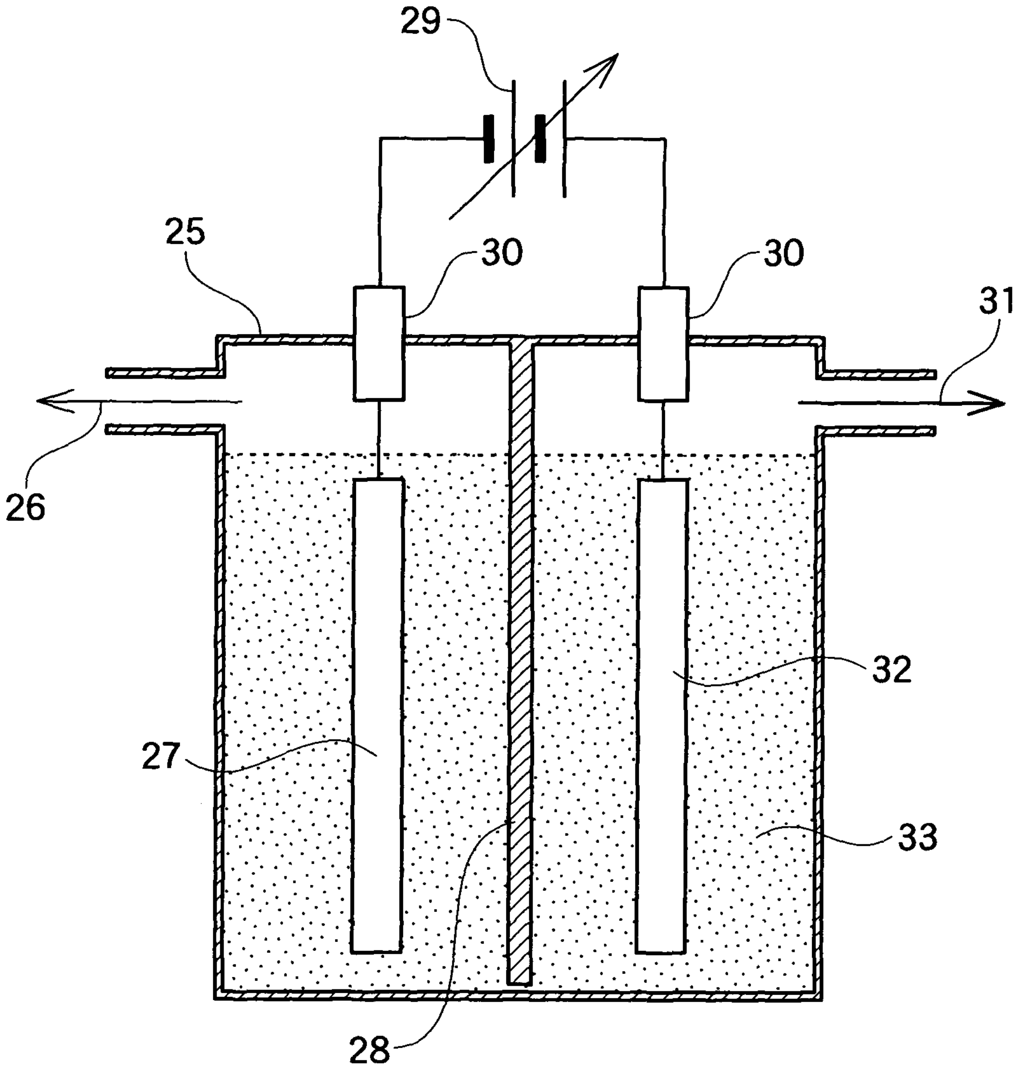

*Fig. 11*

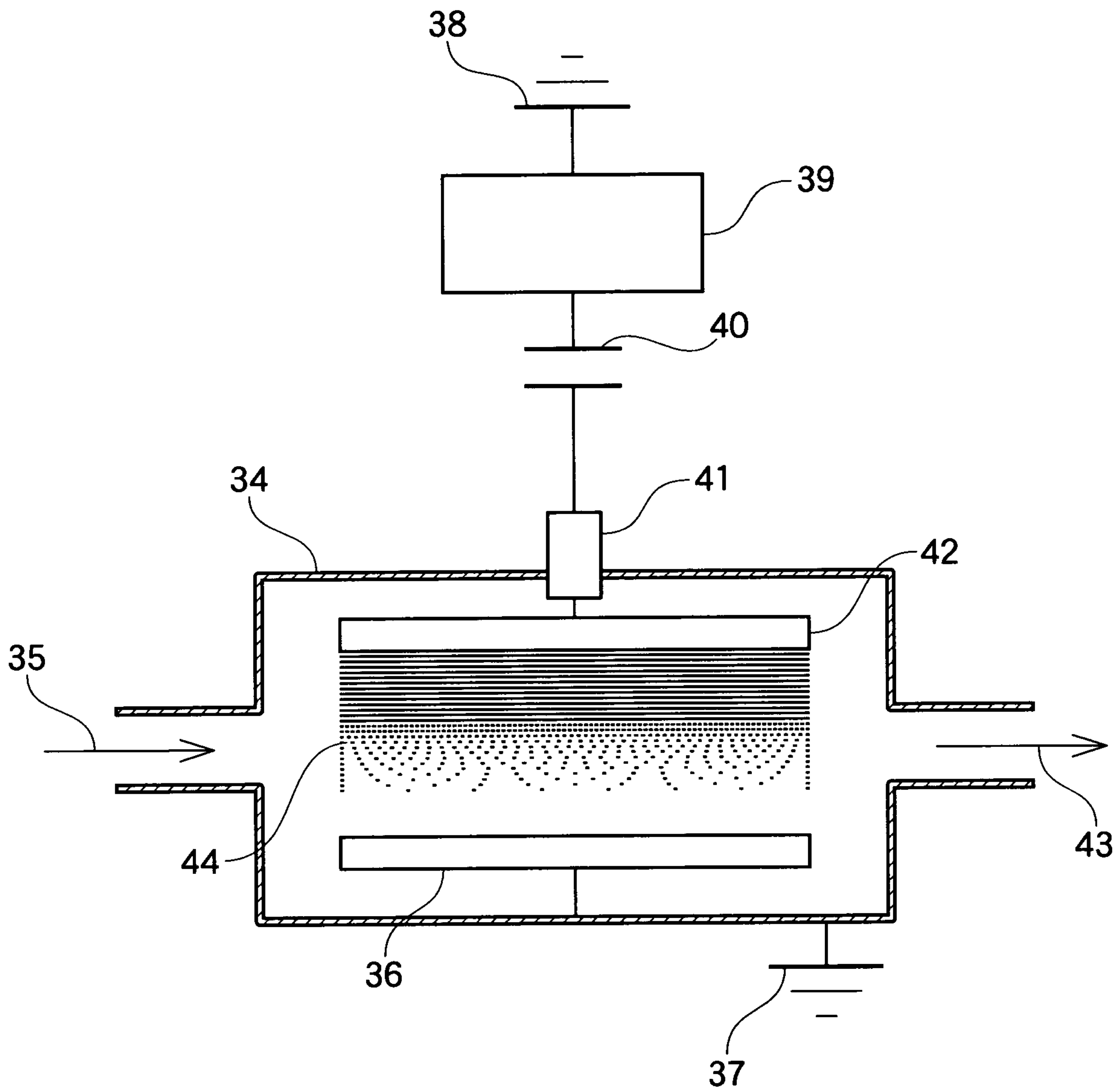

*Fig. 12*

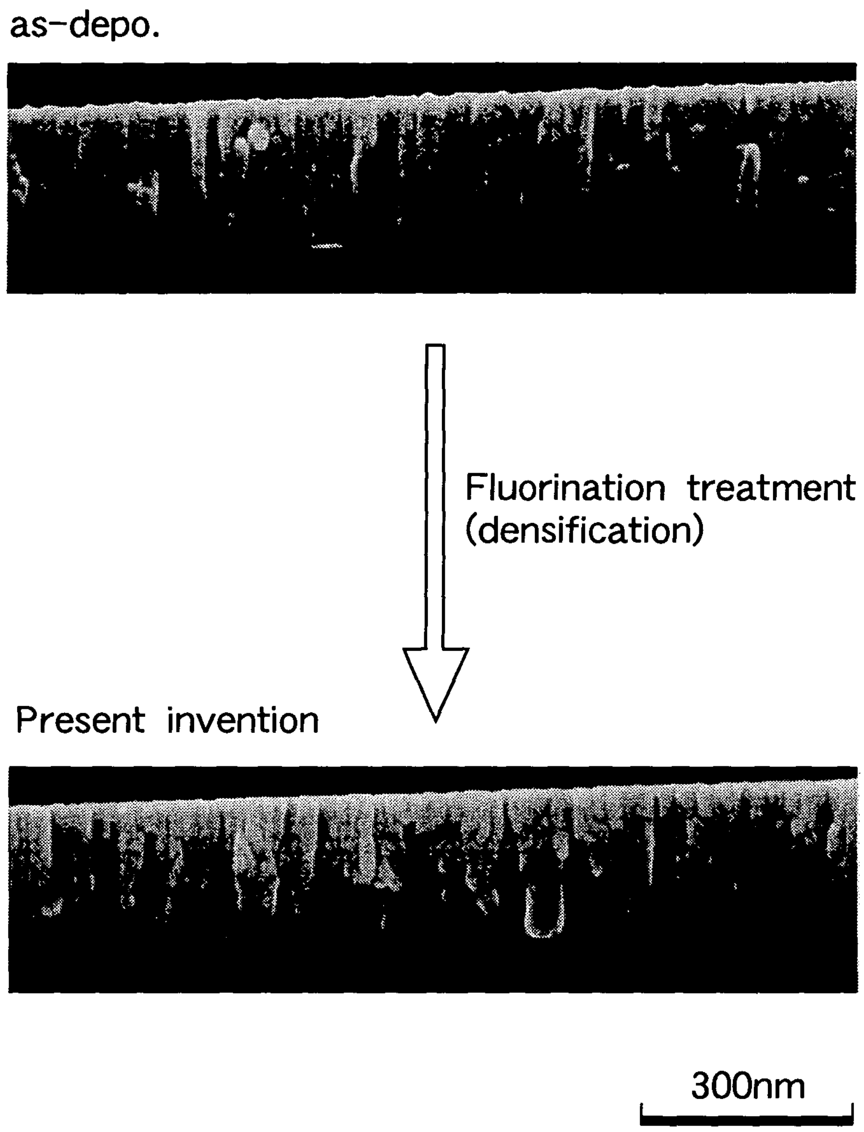
as-depo.
Fluorination treatment
(densification)
Present invention
300nm

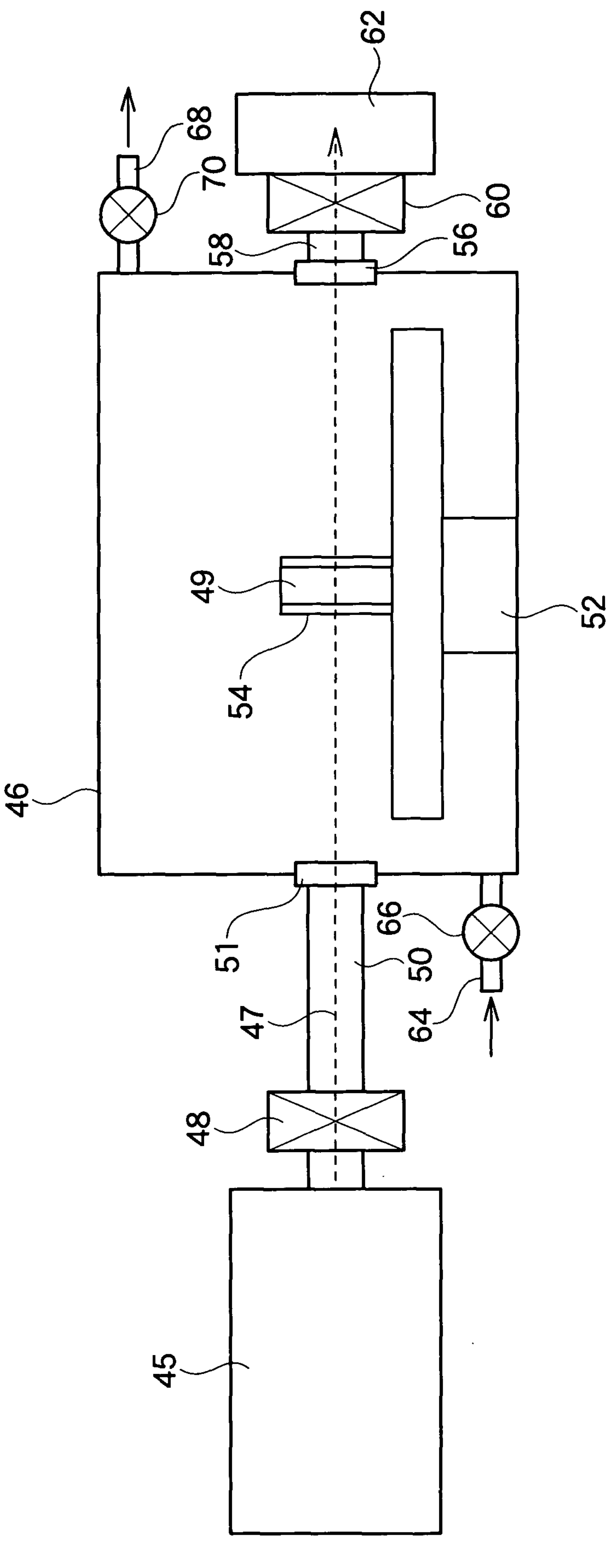


*Fig. 13*

*Fig. 14*

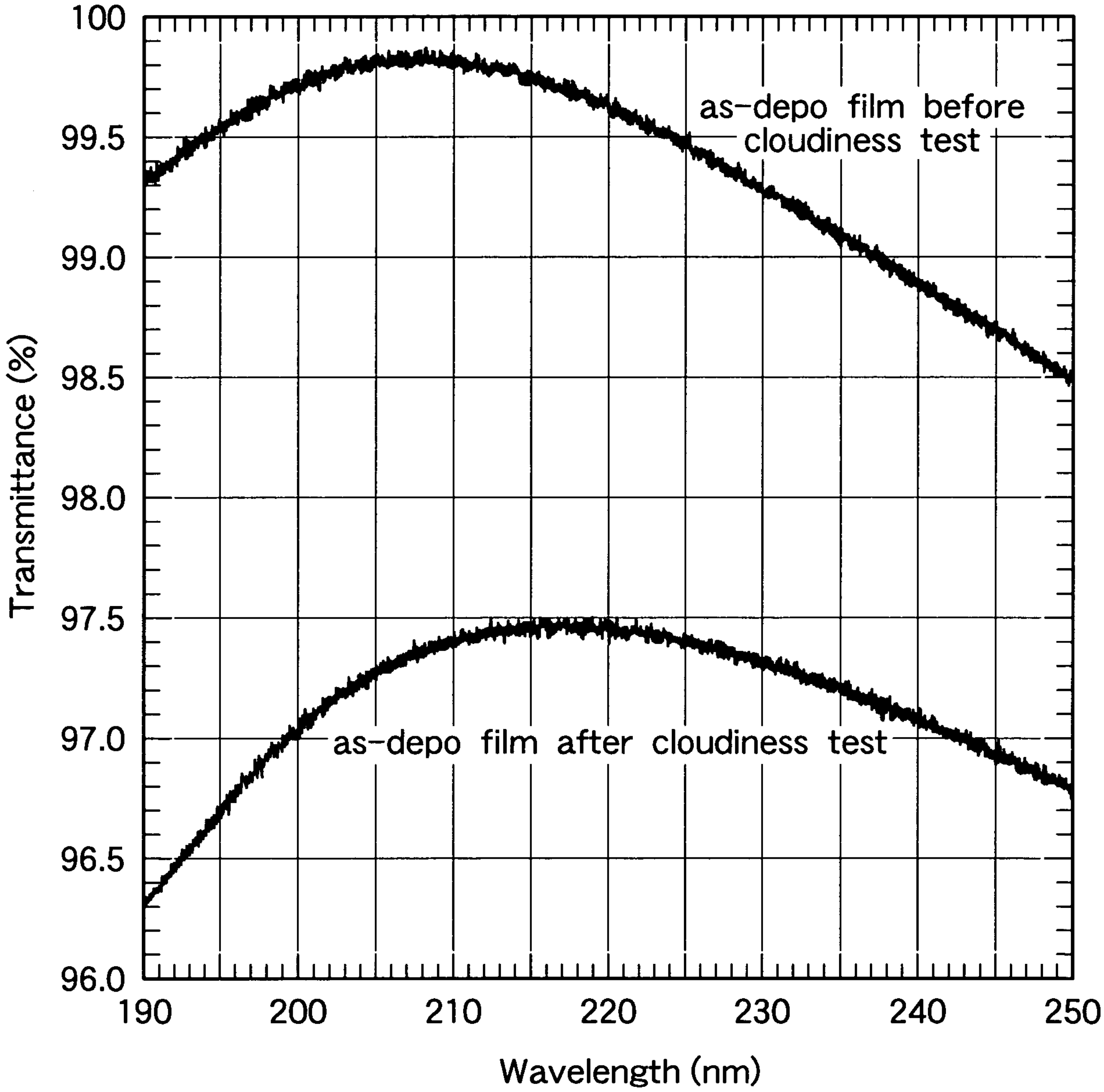
100
99.5
99.0
98.5
98.0
97.5
97.0
96.5
96.0
Transmittance (%)
190
200
210
220
230
240
250
Wavelength (nm)
as-depo film before cloudiness test
as-depo film after cloudiness test

*Fig. 15*

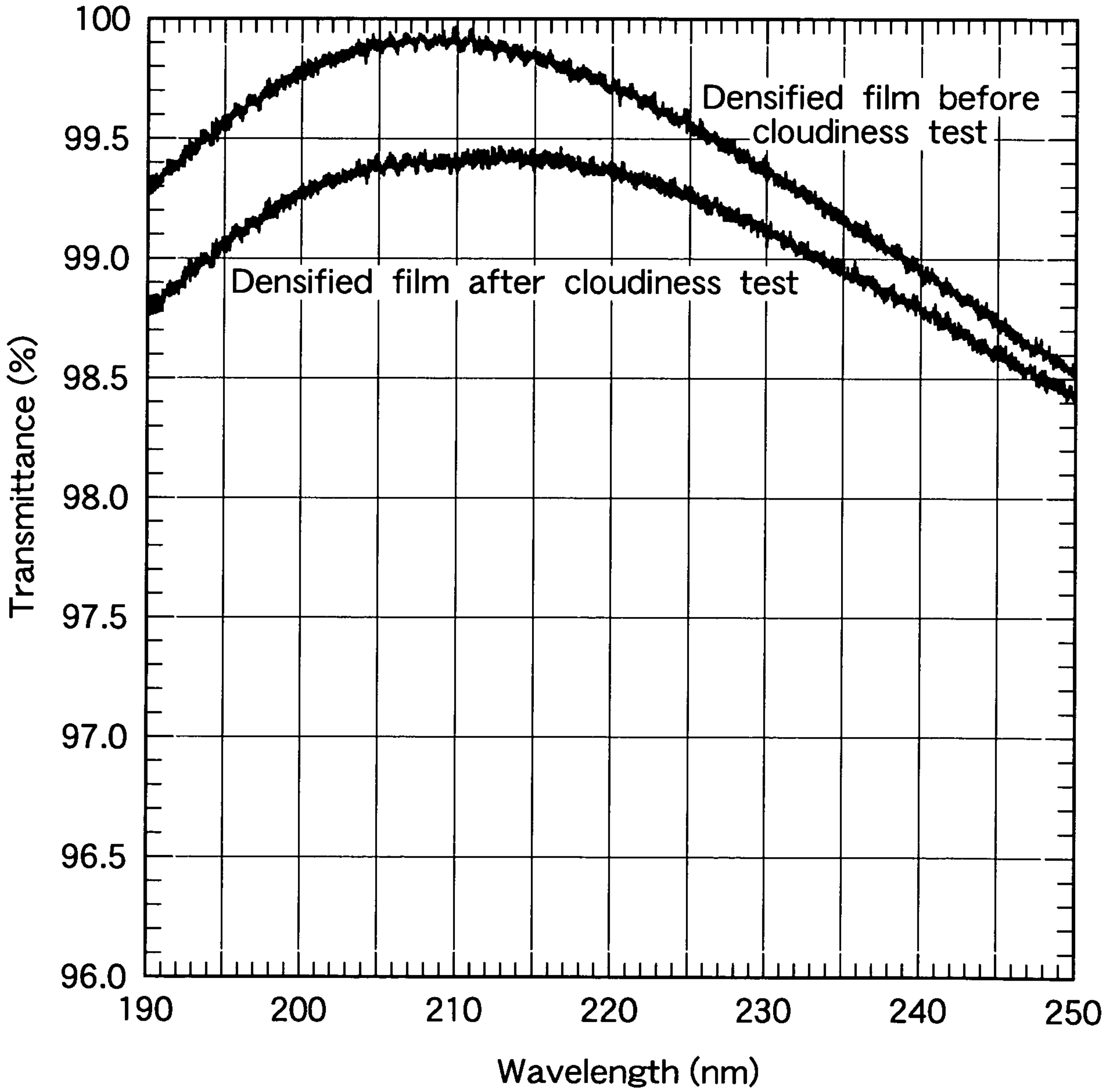
100
99.5
99.0
98.5
98.0
97.5
97.0
96.5
96.0
Transmittance (%)
190
200
210
220
230
240
250
Wavelength (nm)
Densified film before cloudiness test
Densified film after cloudiness test

*Fig. 16*

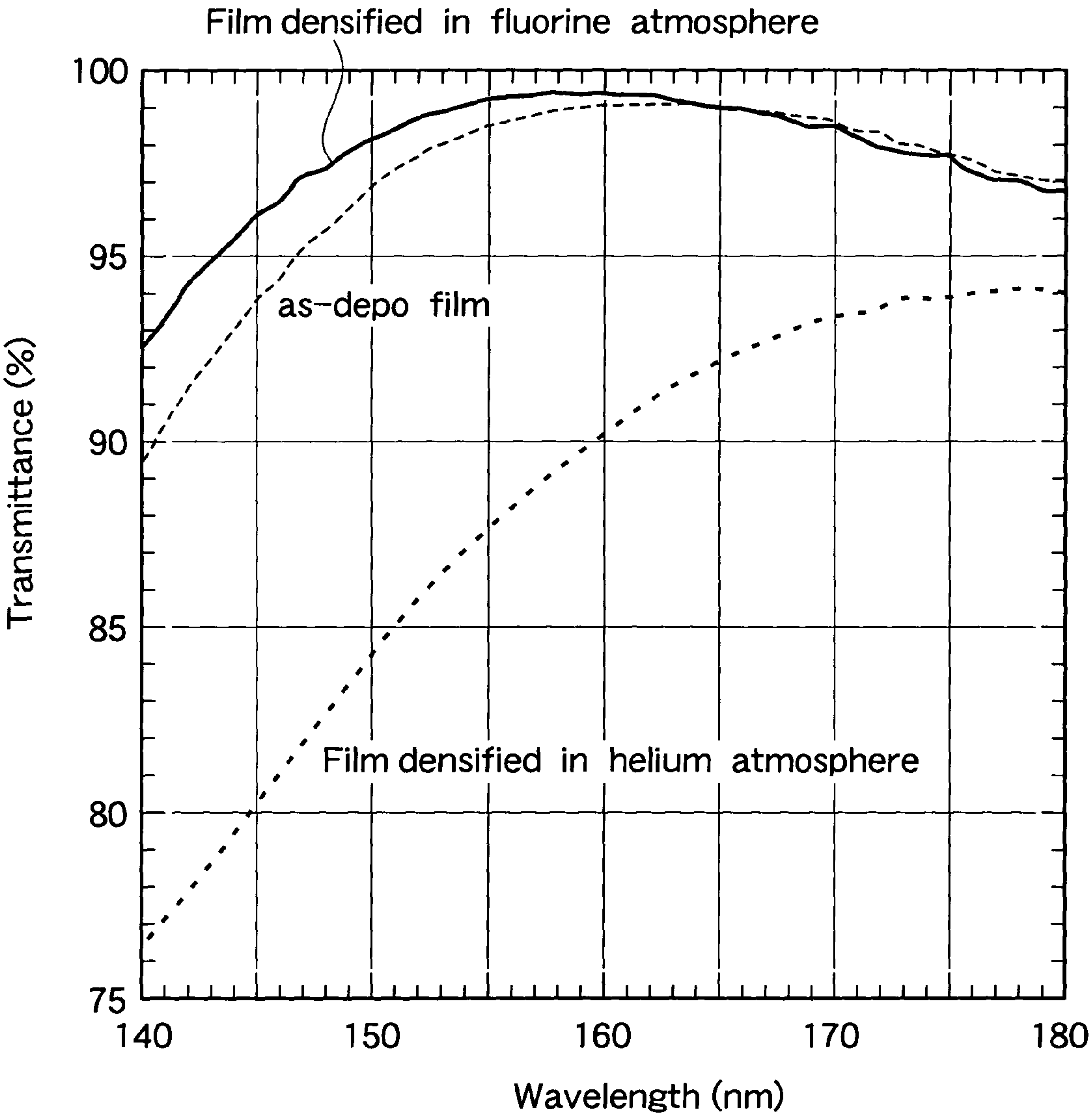
Film densified in fluorine atmosphere
as-depo film
Film densified in helium atmosphere
Transmittance (%)
100
95
90
85
80
75
140
150
160
170
180
Wavelength (nm)